# EUROPEAN PATENT APPLICATION

(11) **EP 4 564 666 A1**
(43) Date of publication of application: **04.06.2025**
(21) Application number: 23871981.9
(22) Date of filing: 14.09.2023
(51) Int. Cl.: H03F 1/02, H03F 3/24, H04B 1/04

(54) **TRACKER CIRCUIT AND TRACKING METHOD**

(30) Priority: 29.09.2022 JP 2022155835
(71) Applicant: Murata Manufacturing Co., Ltd., Nagaokakyo-shi, Kyoto 617-8555 (JP)
(72) Inventor: KOGURE, Takeshi, Nagaokakyo-shi, Kyoto 617-8555 (JP); KATO, Muneharu, Nagaokakyo-shi, Kyoto 617-8555 (JP); MATSUI, Toshiki, Nagaokakyo-shi, Kyoto 617-8555 (JP)
(74) Representative: Stöckeler, Ferdinand
(86) International application number: PCT/JP2023/033626
(87) International publication number: WO 2024/070748

(57) **Abstract**

A tracker circuit (1A) includes: a switched-capacitor circuit (20) configured to generate a plurality of discrete voltages based on a first input voltage; a supply modulator (31) configured to selectively output at least one of the plurality of discrete voltages to a power amplifier (2A); a bypass path (BP1) configured to bypass the switched-capacitor circuit (20) and the supply modulator (31) to output the first input voltage to the power amplifier (2A); and a switch (S66) configured to switch between connection and disconnection of the bypass path (BP1).

## Description

### Technical Field

The present invention relates to a tracker circuit and a tracking method.

### Background Art

The recent application of an envelope tracking (ET) mode to a power amplifier (PA) circuit has led to the improvement of power-added efficiency (PAE). Patent Document 1 discloses a technique related to a digital ET mode for supplying a plurality of discrete voltages.

### Citation List

### Patent Document

Patent Document 1: U.S. Patent No. 9,755,672

### Summary of Invention

### Technical Problem

However, the above technique of the related art can result in reduced power-added efficiency.

The present invention therefore provides a tracker circuit and a tracking method that can improve power-added efficiency.

### Solution to Problem

A tracker circuit according to one aspect of the present invention includes: a converter circuit configured to generate a plurality of discrete voltages based on a first input voltage; a first supply modulator configured to selectively output at least one of the plurality of discrete voltages to a first power amplifier; a first bypass path configured to bypass the converter circuit and the first supply modulator to output the first input voltage to the first power amplifier; and a first switch configured to switch between connection and disconnection of the first bypass path.

A tracker circuit according to one aspect of the present invention includes: a first external connection terminal for receiving a first input voltage; a second external connection terminal connected to a first power amplifier; a switched-capacitor circuit including a first input terminal and a plurality of first output terminals, the first input terminal being connected to the first external connection terminal; a first supply modulator including a plurality of second input terminals and a second output terminal, the plurality of second input terminals being connected to the plurality of first output terminals, the second output terminal being connected to the second external connection terminal; a first bypass path connecting between the first external connection terminal and the second external connection terminal without passing through the switched-capacitor circuit and the first supply modulator; and a first switch connected between the first external connection terminal and the second external connection terminal on the first bypass path.

A tracking method according to one aspect of the present invention includes: in a case of operating a power amplifier in a digital envelope tracking mode, (i) disconnecting a bypass path connecting between a first external connection terminal and a second external connection terminal; (ii) generating a plurality of discrete voltages based on an input voltage received through the first external connection terminal; and (iii) selectively supplying at least one of the plurality of discrete voltages to the power amplifier through the second external connection terminal, based on an envelope of a radio frequency (RF) signal amplified by the power amplifier, and in a case of operating the power amplifier in an average power tracking mode, (i) connecting the bypass path; and (ii) supplying an input voltage received through the first external connection terminal to the power amplifier through the bypass path and the second external connection terminal. Advantageous Effects of Invention

A tracker circuit and the like according to an aspect of the present invention can improve the power-added efficiency.

### Brief Description of Drawings

[Fig. 1A] Fig. 1A is a graph illustrating an example of transition of a power supply voltage in an average power tracking (APT) mode.
[Fig. 1B] Fig 1B is a graph illustrating an example of transition of a power supply voltage in an analog envelope tracking (A-ET) mode.
[Fig. 1C] Fig. 1C is a graph illustrating an example of transition of a power supply voltage in a digital envelope tracking (D-ET) mode.
[Fig. 2] Fig. 2 is a circuit configuration diagram of a communication device according to Embodiment 1.
[Fig. 3] Fig. 3 is a circuit configuration diagram of a switched-capacitor circuit, a supply modulator, and a filter circuit, which are included in a tracker circuit according to Embodiment 1, and a pre-regulator circuit.
[Fig. 4] Fig. 4 is a circuit configuration diagram of a digital control circuit included in the tracker circuit according to Embodiment 1.
[Fig. 5] Fig. 5 is a flowchart illustrating a tracking method according to Embodiment 1.
[Fig. 6] Fig. 6 is a plan view of a tracker module according to Embodiment 1.
[Fig. 7] Fig. 7 is a plan view of the tracker module according to Embodiment 1.
[Fig. 8] Fig. 8 is a cross-sectional view of the tracker module according to Embodiment 1.
[Fig. 9] Fig. 9 is a layout diagram of modules in the communication device according to Embodiment 1.
[Fig. 10] Fig. 10 is a circuit configuration diagram of a tracker circuit according to a modification of Embodiment 1.
[Fig. 11] Fig. 11 is a circuit configuration diagram of a communication device according to Embodiment 2.
[Fig. 12] Fig. 12 is a circuit configuration diagram of a tracker circuit according to Embodiment 2.
[Fig. 13] Fig. 13 is a circuit configuration diagram of a tracker circuit according to Embodiment 3.
[Fig. 14] Fig. 14 is a partial circuit configuration diagram of a communication device according to Embodiment 4.
[Fig. 15] Fig. 15 is a partial circuit configuration diagram of a tracker circuit according to Embodiment 4.

### Description of Embodiments

Hereinafter, embodiments of the present invention will be described in detail with reference to the drawings. Note that the embodiments described below are all comprehensive or specific examples. The numerical values, shapes, materials, components, arrangements and connection forms of the components, and the like described in the following embodiments are merely examples and are not intended to limit the present invention.

Note that each drawing is a schematic diagram that is not necessarily strictly illustrated, in which some components are highlighted or omitted, or ratios are adjusted as necessary to illustrate the present invention. The shapes, positional relationships, and ratios may differ from actual ones. In each drawing, substantially the same configurations are denoted by the same reference numerals, and repetitive description may be omitted or simplified.

In the following drawings, an x-axis and a y-axis are orthogonal to each other on a plane parallel to a main surface of a module laminate. Specifically, when the module laminate has a rectangular shape in plan view, the x-axis is parallel to the first side of the module laminate, and the y-axis is parallel to the second side of the module laminate that is orthogonal to the first side. A z-axis is perpendicular to the main surface of the module laminate, with its positive direction indicating an upward direction and its negative direction indicating a downward direction.

In a circuit configuration of the present invention, "connected" includes not only direct connection by a connection terminal and/or wiring conductor, but also electrical connection through other circuit elements. "Directly connected" means direct connection by a connection terminal and/or wiring conductor without any other circuit elements. "Connected between A and B" means connection to both A and B between A and B, and means series connection to a path between A and B. The "path between A and B" means a path formed by a conductor that electrically connects A to B. "Connected in series to a path" means series connection to a path, and means connection between one end of the path and the other end of the path. "Connected in shunt with a path" means connection between the path and ground.

In the component arrangement of the present invention, "a component is disposed on a laminate" includes the arrangement of the component on the main surface of the laminate and arrangement of the component within the laminate. "A component is disposed on the main surface of the laminate" includes the arrangement of the component in contact with the main surface of the laminate, as well as the arrangement of the component above the main surface with the component not in contact with the main surface (for example, laminating the component on another component disposed in contact with the main surface). "A component is disposed on the main surface of the laminate" may also include the arrangement of the component in a recess formed in the main surface. "A component is disposed within the laminate" includes encapsulation of the component within the module laminate, as well as the arrangement of the entire component between both main surfaces of the laminate with the component partially not covered with the laminate, and the arrangement of only a part of the component within the laminate.

In the component arrangement of the present invention, "planar view of the module laminate" means an orthographically projected view of an object on the xy plane from the positive side of the z-axis. "A overlaps with B in plan view" means that at least a part of a region of A orthographically projected onto the xy plane overlaps with at least a part of a region of B orthographically projected onto the xy plane. "A is disposed between B and C" means that at least one of a plurality of line segments connecting any point in B and any point in C passes through A.

In the component arrangement of the present invention, "A is disposed adjacent to B" means that A and B are disposed in close proximity to each other, and specifically, that no other circuit components exist in the space where A faces B. In other words, "A is disposed adjacent to B" means that none of a plurality of line segments that reach B from any point on the surface of A facing B along the normal direction of the surface passes through circuit components other than A and B. Here, the circuit components refer to components including active elements and/or passive elements. More specifically, circuit components include an active component such as a transistor or a diode, and a passive component such as an inductor, a transformer, a capacitor, or a resistor, but do not include electromechanical components such as a terminal, a connector, or wiring. The distance between two objects means the shortest distance between the two objects. Specifically, the distance between two objects means the length of the shortest line segment among a plurality of line segments connecting any point on one of the two objects to any point on the other of the two objects.

In the present invention, the term "terminal" means a point at which a conductor in an element ends. Note that, when the impedance of a conductor between elements is sufficiently low, a terminal is interpreted not only as a single point, but also as any point on the conductor between the elements or the entire conductor.

The terms indicating the relationship between elements, such as "parallel" and "perpendicular", the term indicating the shape of the element, such as "rectangular", and numerical ranges do not only represent strict meanings, but also include substantially the same ranges, for example, errors of about several percent.

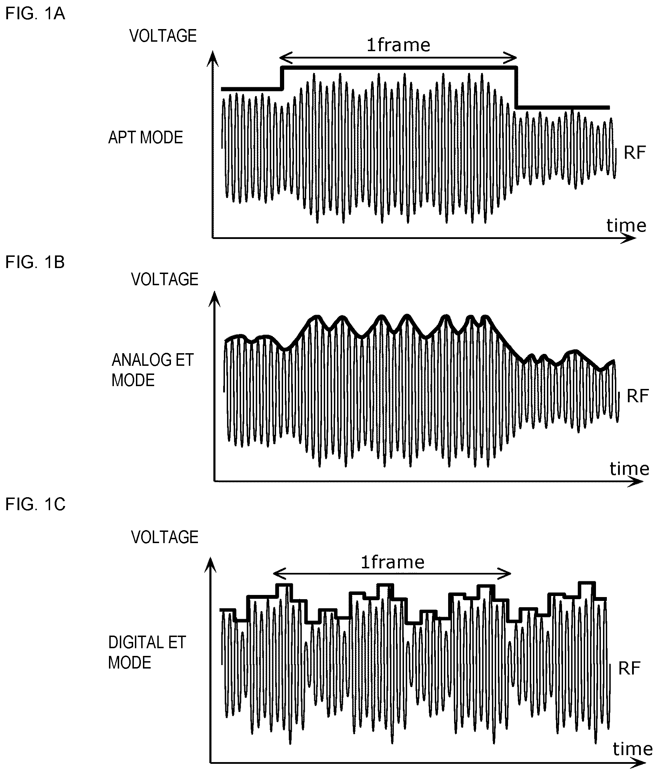

First, as a technique to amplify a radio frequency (RF) signal with high efficiency, a tracking mode will be described, which supplies a power amplifier with a power supply voltage that is dynamically adjusted over time based on the RF signal. The tracking mode is a mode for dynamically adjusting the power supply voltage applied to the power amplifier. While there are several types of tracking modes, an APT mode and an ET mode (including an analog ET mode and a digital ET mode) will be described here with reference to Figs. 1A to 1C. In Figs. 1A to 1C, the horizontal axis represents time and the vertical axis represents voltage. The thick solid line represents the power supply voltage, and the thin solid line (waveform) represents a modulated signal.

Fig. 1A is a graph illustrating an example of the transition of the power supply voltage in the APT mode. In the APT mode, the power supply voltage is changed to a plurality of discrete voltage levels in unit of a frame based on the average power. As a result, a power supply voltage signal forms a rectangular wave.

A frame is a unit that constitutes an RF signal (modulated signal). In 5GNR (5th Generation New Radio) and LTE (Long Term Evolution), for example, a frame includes ten subframes, each subframe includes a plurality of slots, and each slot includes a plurality of symbols. The subframe length is 1 ms, and the frame length is 10 ms.

Note that a mode in which the voltage level is changed in unit of a frame or larger based on the average power is called the APT mode, and is distinguished from a mode in which the voltage level is changed in unit smaller than one frame (for example, a subframe, slot or symbol). For example, a mode in which the voltage level is changed in unit of a symbol is called a symbol power tracking (SPT) mode, and is distinguished from the APT mode.

Fig. 1B is a graph illustrating an example of the transition of the power supply voltage in the analog ET mode. In the analog ET mode, the envelope of the modulated signal is tracked by continuously changing the power supply voltage based on an envelope signal.

The envelope signal is a signal indicating the envelope of a modulated signal. An envelope value is expressed by the square root of (I²+Q²), for example. Here, (I, Q) represents a constellation point. The constellation point is a point that represents a signal modulated by digital modulation on a constellation diagram. (I, Q) is determined by a baseband integrated circuit (BBIC), for example, based on transmission information, for example.

Fig. 1C is a graph illustrating an example of the transition of the power supply voltage in the digital ET mode. In the digital ET mode, the envelope of a modulated signal is tracked by changing the power supply voltage to a plurality of discrete voltage levels within one frame, based on an envelope signal. As a result, a power supply voltage signal forms a rectangular wave.

### (Embodiment 1)

Embodiment 1 will be described below. A communication device 7A according to this embodiment is an example of a high-frequency communication system, and corresponds to a user terminal (UE: User Equipment) in a cellular network, typically a mobile phone, a smartphone, a tablet computer, a wearable device or the like. The communication device 7A may be an IoT (Internet of Things) sensor device, a medical/healthcare device, a car, an unmanned aerial vehicle (UAV) (so-called drone) or an automated guided vehicle (AGV). The communication device 7A may also function as a base station (BS) in the cellular network.

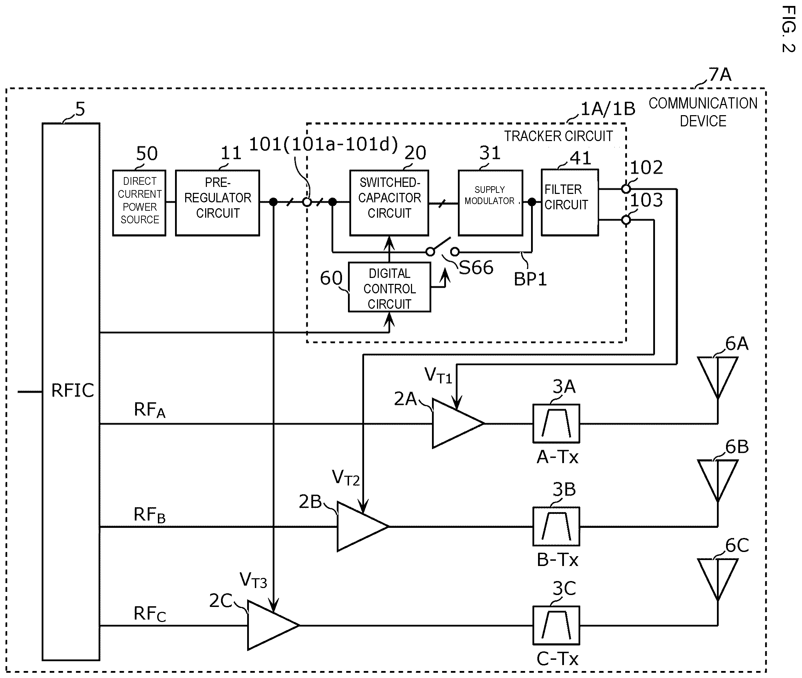

A circuit configuration of the communication device 7A and a tracker circuit 1A according to this embodiment will be described with reference to Fig. 2. Fig. 2 is a circuit configuration diagram of the communication device 7A according to this embodiment.

Fig. 2 illustrates an exemplary circuit configuration, and the communication device 7A and the tracker circuit 1A can be implemented using any of a wide variety of circuit implementations and circuit technologies. Therefore, the description of the communication device 7A and the tracker circuit 1A provided below should not be interpreted as being limited thereto.

### [1.1 Circuit Configuration of Communication Device 7A]

First, the communication device 7A according to this embodiment will be described with reference to Fig. 2. The communication device 7A includes the tracker circuit 1A, power amplifiers 2A to 2C, filters 3A to 3C, a radio frequency integrated circuit (RFIC) 5, antennas 6A to 6C, a pre-regulator circuit 11, and a direct current (DC) power source 50.

The tracker circuit 1A can supply a power supply voltage V_{T1} to the power amplifier 2A based on the digital ET mode or the APT mode. Note that a symbol power tracking (SPT) mode or the like may be used instead of the digital ET mode.

As illustrated in Fig. 2, the tracker circuit 1A includes a switched-capacitor circuit 20, a supply modulator 31, a filter circuit 41, a digital control circuit 60, external connection terminals 101a to 101d, 102, and 103, a bypass path BP1, and a switch S66.

The external connection terminals 101a to 101d are each an example of a first external connection terminal for receiving a regulating voltage (an example of a first input voltage) from the pre-regulator circuit 11. The external connection terminals 101a to 101d are each connected to the pre-regulator circuit 11 outside the tracker circuit 1A, and connected to the switched-capacitor circuit 20 inside the tracker circuit 1A. Note that the tracker circuit 1A only needs to include at least one of the external connection terminals 101a to 101d, and does not necessarily need to include all of the external connection terminals 101a to 101d. Hereinafter, the external connection terminals 101a to 101d may be referred to as external connection terminals 101 unless necessary to distinguish them from each other.

The external connection terminal 102 is an example of a second external connection terminal, which is connected to the power amplifier 2A outside the tracker circuit 1A and connected to the filter circuit 41 inside the tracker circuit 1A. The external connection terminal 102 is a terminal for supplying the power supply voltage V_{T1} to the power amplifier 2A.

The external connection terminal 103 is an example of a third external connection terminal, which is connected to the power amplifier 2B outside the tracker circuit 1A and connected to the filter circuit 41 inside the tracker circuit 1A. The external connection terminal 103 is a terminal for supplying a power supply voltage V_{T2} to the power amplifier 2B. The external connection terminal 103 does not have to be included in the tracker circuit 1A.

The switched-capacitor circuit 20 is an example of a second converter circuit, which includes a plurality of capacitors and a plurality of switches. The switched-capacitor circuit 20 can generate a plurality of discrete voltages, each having a plurality of discrete voltage levels, based on an input voltage received from the pre-regulator circuit 11. The switched-capacitor circuit 20 may also be referred to as a switched-capacitor voltage balancer.

The supply modulator 31 is an example of a first supply modulator, which is configured to selectively output at least one of the plurality of discrete voltages generated by the switched-capacitor circuit 20 to the power amplifiers 2A and 2B. Specifically, the supply modulator 31 can select at least one voltage from among the plurality of discrete voltages and output the selected at least one voltage to the power amplifiers 2A and 2B. In this event, the supply modulator 31 can discretely change the level of the voltage outputted to the power amplifiers 2A and 2B over time by repeating the selection operation. Such a supply modulator 31 is controlled based on a digital control signal.

The filter circuit 41 is an example of a first filter circuit, which is connected between the supply modulator 31 and the power amplifiers 2A and 2B (external connection terminals 102 and 103). The filter circuit 41 is configured to attenuate noise components from signals (a plurality of discrete voltages) from the supply modulator 31.

The digital control circuit 60 can control the pre-regulator circuit 11, the switched-capacitor circuit 20, the supply modulator 31, and the filter circuit 41, based on a digital control signal from the RFIC 5.

The tracker circuit 1A does not have to include at least one of the switched-capacitor circuit 20, the supply modulator 31, the filter circuit 41, and the digital control circuit 60. For example, the tracker circuit 1A does not have to include the digital control circuit 60. Any combination of the switched-capacitor circuit 20, the supply modulator 31, and the filter circuit 41 may be integrated into a single circuit.

The pre-regulator circuit 11 is an example of a first converter circuit, which is configured to convert a voltage from the DC power source 50 into a regulating voltage (an example of the first input voltage). The pre-regulator circuit 11 can output the regulating voltage to the tracker circuit 1A, and can also output the regulating voltage to the power amplifier 2C without passing through the tracker circuit 1A. Specifically, the pre-regulator circuit 11 includes a power inductor and a switch. The power inductor is an inductor used to raise and/or lower a direct current (DC) voltage. The power inductor is connected in series to a direct current (DC) path. The power inductor may also be connected in shunt with the DC path. Such a pre-regulator circuit 11 may also be referred to as a magnetic regulator or a DC-to-DC converter.

The DC power source 50 can supply a DC voltage to the pre-regulator circuit 11. The DC power source 50 may be, for example, a rechargeable battery, but the present invention is not limited thereto.

The power amplifier 2A is an example of a first power amplifier, which is connected between the RFIC 5 and the filter 3A. The power amplifier 2A is also connected to the tracker circuit 1A and can receive the power supply voltage V_{T1} based on the digital ET mode or the APT mode. The power amplifier 2A can use the power supply voltage V_{T1} received from the tracker circuit 1A to amplify an RF signal RF_{A} of a band A received from the RFIC 5. Specifically, the power amplifier 2A can selectively operate in the digital ET mode and the APT mode.

The power amplifier 2B is an example of a second power amplifier, which is connected between the RFIC 5 and the filter 3B. The power amplifier 2B is also connected to the tracker circuit 1A and can receive the power supply voltage V_{T2} based on the digital ET mode or the APT mode. The power amplifier 2B can use the power supply voltage V_{T2} received from the tracker circuit 1A to amplify an RF signal RF_{B} of a band B received from the RFIC 5. Specifically, the power amplifier 2B can selectively operate in the digital ET mode and the APT mode. The power amplifier 2B does not have to be included in the communication device 7A.

The power amplifier 2C is an example of a third power amplifier, which is connected between the RFIC 5 and the filter 3C. The power amplifier 2C is also connected to the pre-regulator circuit 11 and can receive a power supply voltage V_{T3} based on the APT mode from the pre-regulator circuit 11. The power amplifier 2B can use the power supply voltage V_{T3} received from the pre-regulator circuit 11 to amplify an RF signal RF_{C} of a band C received from the RFIC 5. Specifically, the power amplifier 2C can operate in the APT mode. The power amplifier 2C does not have to be included in the communication device 7A.

The filter 3A is connected between the power amplifier 2A and the antenna 6A. The filter 3A is a band pass filter having a passband including a transmission band of the band A. The filter 3A does not have to be included in the communication device 7A.

The filter 3B is connected between the power amplifier 2B and the antenna 6B. The filter 3B is a band pass filter having a passband including a transmission band of the band B. The filter 3B does not have to be included in the communication device 7A.

The filter 3C is connected between the power amplifier 2C and the antenna 6C. The filter 3C is a band pass filter having a passband including a transmission band of the band C. The filter 3C does not have to be included in the communication device 7A.

Each of the bands A to C is a frequency band for a communication system built using a radio access technology (RAT), and is predefined by a standardizing body or the like (for example, 3GPP (registered trademark) (3rd Generation Partnership Project), IEEE (Institute of Electrical and Electronics Engineers) and the like). Examples of the communication system include a 5GNR (5th Generation New Radio) system, a 4GLTE (4th Generation Long Term Evolution) system, a 3G (3rd Generation) system, a 2G (2nd Generation) system, a WLAN (Wireless Local Area Network) system, and the like.

A frequency band included in an ultra-high band group (3300 to 5000 MHz), for example, is used as the band A. Note that the band A is not limited to the frequency band included in the ultra-high band group.

A frequency band included in the ultra-high band group, for example, is used as the band B. Note that the band B is not limited to the frequency band included in the ultra-high band group.

A frequency band included in a mid-high band group (1427 to 2690 MHz) or a low band group (698 to 960 MHz), for example, is used as the band C. For example, a frequency band used in a 2G communication system may also be used as the band C. Note that the band C is not limited to the frequency band included in the mid-high band group or low band group and to the frequency band used in the 2G communication system.

Note that the transmission band refers to a frequency band used for transmission in the communication device. For example, in a frequency division duplex (FDD) band, a frequency band different from a reception band is used as the transmission band. In a time division duplex (TDD) band, on the other hand, the same frequency band as the reception band is used as the transmission band. When the communication device functions as a UE of a cellular network, in particular, an uplink operation band is used as the transmission band in the FDD band. When the communication device functions as a BS of the cellular network, on the other hand, a downlink operation band is used as the transmission band in the FDD band.

The RFIC 5 is an example of a signal processing circuit that processes RF signals. Specifically, the RFIC 5 processes an inputted transmission signal by up-conversion or the like, and supplies the high-frequency transmission signal thus generated through signal processing to the power amplifiers 2A to 2C. The RFIC 5 may also include a control unit that controls the tracker circuit 1A. Note that part or all of the function of the RFIC 5 as the control unit may be implemented outside the RFIC 5.

The antenna 6A outputs a transmission signal of the band A inputted from the power amplifier 2A through the filter 3A. The antenna 6A does not have to be included in the communication device 7A.

The antenna 6B outputs a transmission signal of the band B inputted from the power amplifier 2B through the filter 3B. The antenna 6B does not have to be included in the communication device 7A.

The antenna 6C outputs a transmission signal of the band C inputted from the power amplifier 2C through the filter 3C. The antenna 6C does not have to be included in the communication device 7A.

The bypass path BP1 is an example of a first bypass path, which is configured to bypass the switched-capacitor circuit 20 and the supply modulator 31 and output the regulating voltage from the pre-regulator circuit 11 to the power amplifiers 2A and 2B. Specifically, the bypass path BP1 connects the external connection terminals 101 and 102 without passing through the switched-capacitor circuit 20 and the supply modulator 31. The bypass path BP1 also connects the external connection terminals 101 and 103 without passing through the switched-capacitor circuit 20 and the supply modulator 31.

The switch S66 is an example of a first switch, which is configured to switch between connection and disconnection of the bypass path BP1. Specifically, the switch S66 is connected between the external connection terminals 101 and 102 on the bypass path BP1. The switch S66 is also connected between the external connection terminals 101 and 103 on the bypass path BP1. That is, one end of the switch S66 is connected to the external connection terminal 101, while the other end of the switch S66 is connected to the external connection terminals 102 and 103 through the filter circuit 41.

The switch S66 thus connected is switched on and off based on a control signal S4. For example, the on and off of the switch S66 is controlled as follows. (1) When the RF signal RF_{A} or RF_{B} is transmitted in a first power class, the switch S66 is opened (turned off). That is, the bypass path BP1 is disconnected, and the regulating voltage received through the external connection terminal 101 is supplied to the switched-capacitor circuit 20. As a result, a plurality of discrete voltages are generated in the switched-capacitor circuit 20, and the supply modulator 31 selectively outputs at least one of the plurality of discrete voltages to the external connection terminal 102 or 103. This causes the power amplifier 2A or 2B to operate in the digital ET mode. (2) When the RF signal RF_{A} or RF_{B} is transmitted in a second power class, the switch S66 is closed (turned on). That is, the bypass path BP1 is connected, and the regulating voltage received through the external connection terminal 101 is outputted to the external connection terminal 102 or 103 through the filter circuit 41. This causes the power amplifier 2A or 2B to operate in the APT mode.

Here, the first power class is a power class that allows a maximum output power higher than the second power class. In other words, the maximum output power allowed by the first power class is higher than the maximum output power allowed by the second power class.

The power class is classification of output power of a terminal, which is defined by the maximum output power or the like. The smaller the power class value, the higher the maximum output power allowed. For example, in 3GPP, the maximum output power of power class 1 is 31 dBm, the maximum output power of power class 1.5 is 29 dBm, the maximum output power of power class 2 is 26 dBm, and the maximum output power of power class 3 is 23 dBm.

The maximum output power of a terminal is defined by the output power at the antenna end of the terminal. The maximum output power of the terminal is measured, for example, by a method defined by 3GPP or the like. For example, in Fig. 2, the output power is measured by measuring radiated power of the antennas 6A to 6C. Note that, instead of measuring the radiated power, the output power of the antennas 6A to 6C can also be measured by providing terminals near the antennas 6A to 6C and connecting a measuring instrument (such as a spectrum analyzer) to the terminals.

For example, power class 2 and power class 3 are used as the first power class and the second power class, respectively. Note that the combination of the first power class and the second power class is not limited to the combination of power class 2 and power class 3. For example, the combination of the first power class and the second power class may be the combination of power class 1.5 and power class 2 or the combination of power class 1.5 and power class 3.

Although the case where the switch S66 is controlled based on the power class has been described here, the control of the switch S66 is not limited to such control based on the power class.

The circuit configuration of the communication device 7A illustrated in Fig. 2 is merely an example, and the present invention is not limited to this example. For example, the communication device 7A may include a baseband signal processing circuit that processes signals using an intermediate frequency band that is lower than the RF signals RF_{A} to RF_{C}. The communication device 7A may also include a receive path. The communication device 7A may further include one or more power amplifiers connected to the tracker circuit 1A, in addition to the power amplifiers 2A and 2B. The communication device 7A may further include one or more power amplifiers connected to the pre-regulator circuit 11, in addition to the power amplifier 2C.

### [1.2 Circuit Configuration of Tracker Circuit 1A and Pre-regulator Circuit 11]

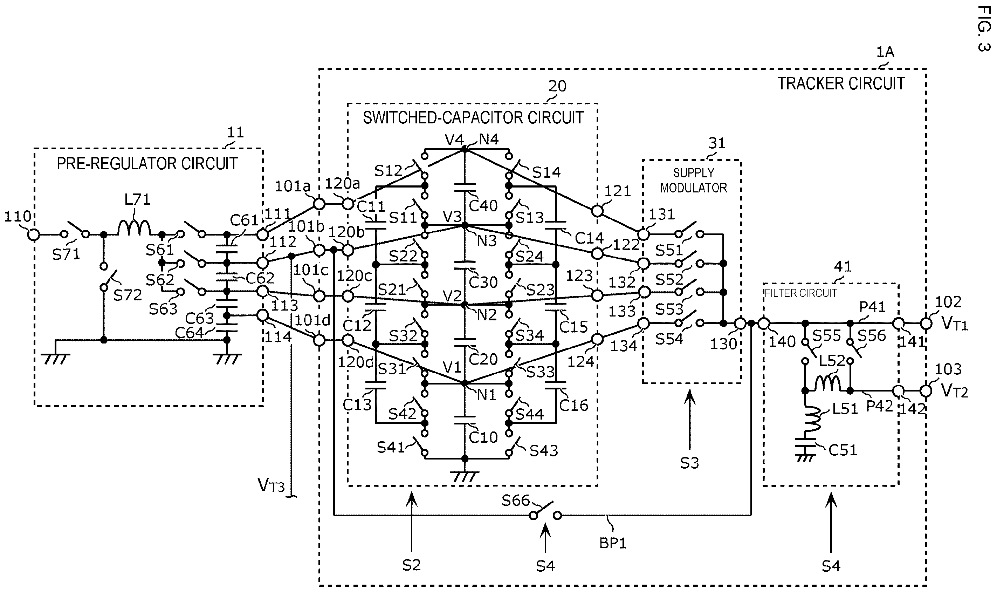

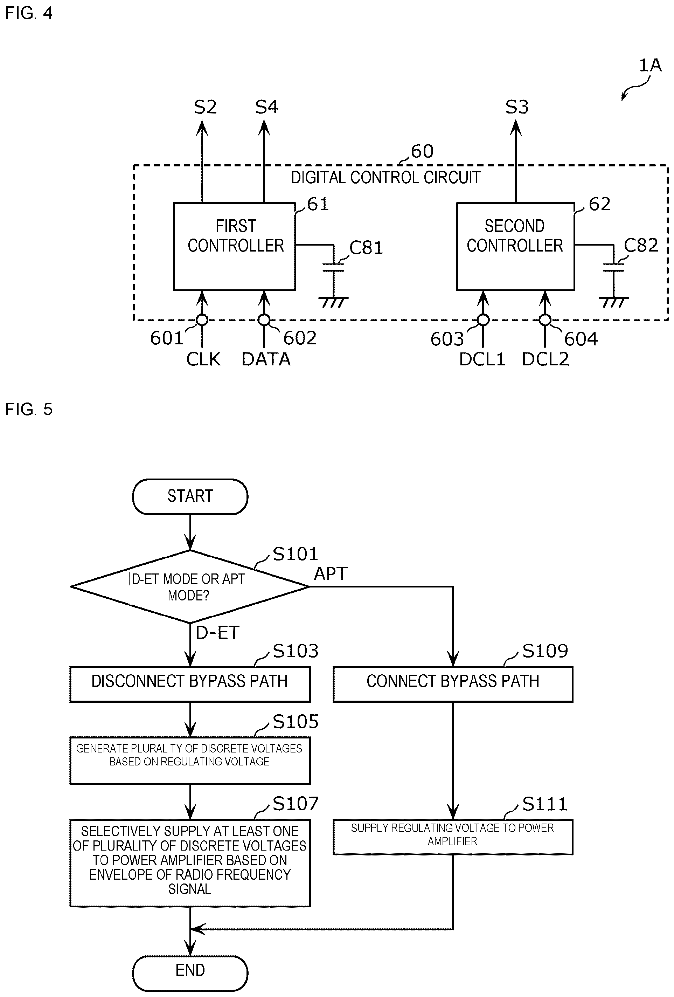

Next, a circuit configuration of the tracker circuit 1A and the pre-regulator circuit 11 will be described with reference to Figs. 3 and 4. Fig. 3 is a circuit configuration diagram of the switched-capacitor circuit 20, the supply modulator 31, and the filter circuit 41 included in the tracker circuit 1A according to this embodiment, and the pre-regulator circuit 11. Fig. 4 is a circuit configuration diagram of the digital control circuit 60 included in the tracker circuit 1A according to this embodiment.

Note that Figs. 3 and 4 illustrate exemplary circuit configurations, and the pre-regulator circuit 11, the switched-capacitor circuit 20, the supply modulator 31, the filter circuit 41, and the digital control circuit 60 can be implemented using any of a wide variety of circuit implementations and circuit technologies. Therefore, the description of each circuit provided below should not be interpreted as being limited thereto.

### [1.2.1 Circuit Configuration of Switched-capacitor Circuit 20]

First, a circuit configuration of the switched-capacitor circuit 20 will be described. As illustrated in Fig. 3, the switched-capacitor circuit 20 includes capacitors C11 to C16, capacitors C10, C20, C30, and C40, switches S11 to S14, S21 to S24, S31 to S34, and S41 to S44, input terminals 120a to 120d, and output terminals 121 to 124.

The input terminals 120a to 120d are each an example of a first input terminal. The input terminals 120a to 120d are connected to the external connection terminals 101a to 101d of the tracker circuit 1A, respectively, outside the switched-capacitor circuit 20, and connected to nodes N4 to N1, respectively, inside the switched-capacitor circuit 20. Note that some or all of the input terminals 120a to 120d may be hereinafter referred to as input terminals 120.

The output terminals 121 to 124 are an example of a plurality of first output terminals. The output terminals 121 to 124 are connected to input terminals 131 to 134 of the supply modulator 31, respectively, outside the switched-capacitor circuit 20, and connected to the nodes N4 to N1, respectively, inside the switched-capacitor circuit 20.

Energy and charges are inputted from the pre-regulator circuit 11 to the switched-capacitor circuit 20 through the input terminals 120a to 120d, and are drawn from the switched-capacitor circuit 20 to the supply modulator 31 through the output terminals 121 to 124.

The capacitors C11 to C16 each function as a flying capacitor (sometimes referred to as a transfer capacitor). Specifically, the capacitors C11 to C16 are each used to raise or lower the regulating voltage supplied from the pre-regulator circuit 11. More specifically, the capacitors C11 to C16 transfer charges between the capacitors C11 to C16 and the nodes N1 to N4, so that voltages V1 to V4 (voltages relative to ground potential) that satisfy V1:V2:V3:V4 = 1:2:3:4 are maintained at the four nodes N1 to N4. These voltages V1 to V4 correspond to a plurality of discrete voltages having a plurality of discrete voltage levels.

The capacitor C11 has two electrodes. One of the two electrodes of the capacitor C11 is connected to one end of the switch S11 and one end of the switch S12. The other of the two electrodes of the capacitor C11 is connected to one end of the switch S21 and one end of the switch S22.

The capacitor C12 has two electrodes. One of the two electrodes of the capacitor C12 is connected to one end of the switch S21 and one end of the switch S22. The other of the two electrodes of the capacitor C12 is connected to one end of the switch S31 and one end of the switch S32.

The capacitor C13 has two electrodes. One of the two electrodes of the capacitor C13 is connected to one end of the switch S31 and one end of the switch S32. The other of the two electrodes of the capacitor C13 is connected to one end of the switch S41 and one end of the switch S42.

The capacitor C14 has two electrodes. One of the two electrodes of the capacitor C14 is connected to one end of the switch S13 and one end of the switch S14. The other of the two electrodes of the capacitor C14 is connected to one end of the switch S23 and one end of the switch S24.

The capacitor C15 has two electrodes. One of the two electrodes of the capacitor C15 is connected to one end of the switch S23 and one end of the switch S24. The other of the two electrodes of the capacitor C15 is connected to one end of the switch S33 and one end of the switch S34.

The capacitor C16 has two electrodes. One of the two electrodes of the capacitor C16 is connected to one end of the switch S33 and one end of the switch S34. The other of the two electrodes of the capacitor C16 is connected to one end of the switch S43 and one end of the switch S44.

The set of the capacitors C11 and C14, the set of the capacitors C12 and C15, and the set of the capacitors C13 and C16 can each be charged and discharged complementarily by repeating a first phase and a second phase.

Specifically, in the first phase, the switches S12, S13, S22, S23, S32, S33, S42, and S43 are turned on. As a result, for example, one of the two electrodes of the capacitor C12 is connected to the node N3, the other of the two electrodes of the capacitor C12 and one of the two electrodes of the capacitor C15 are connected to the node N2, and the other of the two electrodes of the capacitor C15 is connected to the node N1.

In the second phase, on the other hand, the switches S11, S14, S21, S24, S31, S34, S41, and S44 are turned on. As a result, for example, one of the two electrodes of the capacitor C15 is connected to the node N3, the other of the two electrodes of the capacitor C15 and one of the two electrodes of the capacitor C12 are connected to the node N2, and the other of the two electrodes of the capacitor C12 is connected to the node N1.

By repeating such first and second phases, when one of the capacitors C12 and C15 is charged from the node N2, for example, the other of the capacitors C12 and C15 can be discharged to the capacitor C30. In other words, the capacitors C12 and C15 can be complementarily charged and discharged.

By repeating the first phase and the second phase, the set of the capacitors C11 and C14 and the set of the capacitors C13 and C16 can also be complementarily charged and discharged, as in the case of the set of the capacitors C12 and C15.

The capacitors C10, C20, C30, and C40 each function as a smoothing capacitor. Specifically, the capacitors C10, C20, C30, and C40 are each used to hold and smooth the voltages V1 to V4 at the nodes N1 to N4.

The capacitor C10 is connected between the node N1 and the ground. Specifically, one of the two electrodes of the capacitor C10 is connected to the node N1. The other of the two electrodes of the capacitor C10 is connected to the ground.

The capacitor C20 is connected between the nodes N2 and N1. Specifically, one of the two electrodes of the capacitor C20 is connected to the node N2. The other of the two electrodes of the capacitor C20 is connected to the node N1.

The capacitor C30 is connected between the nodes N3 and N2. Specifically, one of the two electrodes of the capacitor C30 is connected to the node N3. The other of the two electrodes of the capacitor C30 is connected to the node N2.

The capacitor C40 is connected between the nodes N4 and N3. Specifically, one of the two electrodes of the capacitor C40 is connected to the node N4. The other of the two electrodes of the capacitor C40 is connected to the node N3.

The switch S11 is connected between one of the two electrodes of the capacitor C11 and the node N3. Specifically, one end of the switch S11 is connected to one of the two electrodes of the capacitor C11. The other end of the switch S11 is connected to the node N3.

The switch S12 is connected between one of the two electrodes of the capacitor C11 and the node N4. Specifically, one end of the switch S12 is connected to one of the two electrodes of the capacitor C11. The other end of the switch S12 is connected to the node N4.

The switch S21 is connected between one of the two electrodes of the capacitor C12 and the node N2. Specifically, one end of the switch S21 is connected to one of the two electrodes of the capacitor C12 and the other of the two electrodes of the capacitor C11. The other end of the switch S21 is connected to the node N2.

The switch S22 is connected between one of the two electrodes of the capacitor C12 and the node N3. Specifically, one end of the switch S22 is connected to one of the two electrodes of the capacitor C12 and the other of the two electrodes of the capacitor C11. The other end of the switch S22 is connected to the node N3.

The switch S31 is connected between the other of the two electrodes of the capacitor C12 and the node N1. Specifically, one end of the switch S31 is connected to the other of the two electrodes of the capacitor C12 and one of the two electrodes of the capacitor C13. The other end of the switch S31 is connected to the node N1.

The switch S32 is connected between the other of the two electrodes of the capacitor C12 and the node N2. Specifically, one end of the switch S32 is connected to the other of the two electrodes of the capacitor C12 and one of the two electrodes of the capacitor C13. The other end of the switch S32 is connected to the node N2. That is, the other end of the switch S32 is connected to the other end of the switch S21.

The switch S41 is connected between the other of the two electrodes of the capacitor C13 and the ground. Specifically, one end of the switch S41 is connected to the other of the two electrodes of the capacitor C13. The other end of the switch S41 is connected to the ground.

The switch S42 is connected between the other of the two electrodes of the capacitor C13 and the node N1. Specifically, one end of the switch S42 is connected to the other of the two electrodes of the capacitor C13. The other end of the switch S42 is connected to the node N1. That is, the other end of the switch S42 is connected to the other end of the switch S31.

The switch S13 is connected between one of the two electrodes of the capacitor C14 and the node N3. Specifically, one end of the switch S13 is connected to one of the two electrodes of the capacitor C14. The other end of the switch S13 is connected to the node N3. That is, the other end of the switch S13 is connected to the other end of the switch S11 and the other end of the switch S22.

The switch S14 is connected between one of the two electrodes of the capacitor C14 and the node N4. Specifically, one end of the switch S14 is connected to one of the two electrodes of the capacitor C14. The other end of the switch S14 is connected to the node N4. That is, the other end of the switch S14 is connected to the other end of the switch S12.

The switch S23 is connected between one of the two electrodes of the capacitor C15 and the node N2. Specifically, one end of the switch S23 is connected to one of the two electrodes of the capacitor C15 and the other of the two electrodes of the capacitor C14. The other end of the switch S23 is connected to the node N2. That is, the other end of the switch S23 is connected to the other end of the switch S21 and the other end of the switch S32.

The switch S24 is connected between one of the two electrodes of the capacitor C15 and the node N3. Specifically, one end of the switch S24 is connected to one of the two electrodes of the capacitor C15 and the other of the two electrodes of the capacitor C14. The other end of the switch S24 is connected to the node N3. That is, the other end of the switch S24 is connected to the other end of the switch S11, the other end of the switch S22, and the other end of the switch S13.

The switch S33 is connected between the other of the two electrodes of the capacitor C15 and the node N1. Specifically, one end of the switch S33 is connected to the other of the two electrodes of the capacitor C15 and one of the two electrodes of the capacitor C16. The other end of the switch S33 is connected to the node N1. That is, the other end of the switch S33 is connected to the other end of the switch S31 and the other end of the switch S42.

The switch S34 is connected between the other of the two electrodes of the capacitor C15 and the node N2. Specifically, one end of the switch S34 is connected to the other of the two electrodes of the capacitor C15 and one of the two electrodes of the capacitor C16. The other end of the switch S34 is connected to the node N2. That is, the other end of the switch S34 is connected to the other end of the switch S21, the other end of the switch S32, and the other end of the switch S23.

The switch S43 is connected between the other of the two electrodes of the capacitor C16 and the ground. Specifically, one end of the switch S43 is connected to the other of the two electrodes of the capacitor C16. The other end of the switch S43 is connected to the ground.

The switch S44 is connected between the other of the two electrodes of the capacitor C16 and the node N1. Specifically, one end of the switch S44 is connected to the other of the two electrodes of the capacitor C16. The other end of the switch S44 is connected to the node N1. That is, the other end of the switch S44 is connected to the other end of the switch S31, the other end of the switch S42, and the other end of the switch S33.

A first set of switches including the switches S12, S13, S22, S23, S32, S33, S42, and S43 and a second set of switches including the switches S11, S14, S21, S24, S31, S34, S41, and S44 are complementarily switched on and off based on a control signal S2. Specifically, in the first phase, the first set of switches are turned on and the second set of switches are turned off. In the second phase, on the other hand, the first set of switches are turned off and the second set of switches are turned on.

For example, in one of the first and second phases, the capacitors C10 to C40 are charged from the capacitors C11 to C13. In the other of the first and second phases, the capacitors C10 to C40 are charged from the capacitors C14 to C16. Specifically, the capacitors C10 to C40 are constantly charged from the capacitors C11 to C13 or the capacitors C14 to C16. Therefore, even when a current rapidly flows from the nodes N1 to N4 to the supply modulator 31, charges are rapidly supplied to the nodes N1 to N4, thus making it possible to suppress fluctuation in potential at the nodes N1 to N4.

Through such an operation, the switched-capacitor circuit 20 can maintain substantially the same voltage at both ends of the capacitors C10, C20, C30, and C40. Specifically, at the four nodes labeled V1 to V4, the voltages V1 to V4 (voltages relative to the ground potential) that satisfy V1:V2:V3:V4 **=** 1:2:3:4 are maintained. The voltage levels of the voltages V1 to V4 correspond to a plurality of discrete voltage levels of voltages that can be supplied to the supply modulator 31 by the switched-capacitor circuit 20.

The voltage ratio (V1:V2:V3:V4) is not limited to (1:2:3:4). For example, the voltage ratio (V1:V2:V3:V4) may be (1:2:4:8).

The configuration of the switched-capacitor circuit 20 illustrated in Fig. 3 is merely an example, and the present invention is not limited to this example. While, in Fig. 3, the switched-capacitor circuit 20 is configured to be able to supply voltages of four discrete voltage levels, the present invention is not limited thereto. The switched-capacitor circuit 20 may be configured to be able to supply voltages of any number of discrete voltage levels, such as greater than or equal to two. In the case of supplying voltages of two discrete voltage levels, for example, the switched-capacitor circuit 20 may include at least the capacitors C12 and C15 and the switches S21 to S24 and S31 to S34.

### [1.2.2 Circuit Configuration of Supply modulator 31]

Next, a circuit configuration of the supply modulator 31 will be described. The supply modulator 31 is connected to the digital control circuit 60. As illustrated in Fig. 3, the supply modulator 31 includes the input terminals 131 to 134, switches S51 to S54, and an output terminal 130.

The output terminal 130 is an example of a second output terminal, which is connected to the external connection terminals 102 and 103 through the filter circuit 41. The output terminal 130 is a terminal for supplying a power supply voltage selected from among the voltages V1 to V4 to the power amplifier 2A through the external connection terminal 102.

The input terminals 131 to 134 are an example of a plurality of second input terminals, which are connected to the output terminals 121 to 124 of the switched-capacitor circuit 20, respectively. The input terminals 131 to 134 are terminals for receiving the voltages V4 to V1 from the switched-capacitor circuit 20.

The switch S51 is connected between the input terminal 131 and the output terminal 130. Specifically, the switch S51 has a terminal connected to the input terminal 131 and a terminal connected to the output terminal 130. In this connection configuration, the switch S51 can be switched on and off (closed and open) based on a control signal S3, thereby switching between connection and non-connection between the input terminal 131 and the output terminal 130.

The switch S52 is connected between the input terminal 132 and the output terminal 130. Specifically, the switch S52 has a terminal connected to the input terminal 132 and a terminal connected to the output terminal 130. In this connection configuration, the switch S52 can be switched on and off based on the control signal S3, thereby switching between connection and non-connection between the input terminal 132 and the output terminal 130.

The switch S53 is connected between the input terminal 133 and the output terminal 130. Specifically, the switch S53 has a terminal connected to the input terminal 133 and a terminal connected to the output terminal 130. In this connection configuration, the switch S53 can be switched on and off based on the control signal S3, thereby switching between connection and non-connection between the input terminal 133 and the output terminal 130.

The switch S54 is connected between the input terminal 134 and the output terminal 130. Specifically, the switch S54 has a terminal connected to the input terminal 134 and a terminal connected to the output terminal 130. In this connection configuration, the switch S54 can be switched on and off based on the control signal S3, thereby switching between connection and non-connection between the input terminal 134 and the output terminal 130.

These switches S51 to S54 are controlled to be exclusively on. That is, only one of the switches S51 to S54 is turned on, and the rest of the switches S51 to S54 are turned off. This allows the supply modulator 31 to output one voltage selected from among the voltages V1 to V4.

Note that the configuration of the supply modulator 31 illustrated in Fig. 3 is merely an example, and the present invention is not limited to this example. The switches S51 to S54, in particular, may have any configuration as long as at least one of the four input terminals 131 to 134 can be selectively connected to the output terminal 130. For example, the supply modulator 31 may further include a switch connected between the switches S51 to S53 and the switch S54 and the output terminal 130. For example, the supply modulator 31 may also further include a switch connected between the switches S51 and S52, and the switches S53 and S54 and the output terminal 130.

When voltages of two discrete voltage levels are supplied from the switched-capacitor circuit 20, the supply modulator 31 may include at least two of the switches S51 to S54.

### [1.2.3 Circuit Configuration of Pre-regulator Circuit 11]

First, a configuration of the pre-regulator circuit 11 will be described. As illustrated in Fig. 3, the pre-regulator circuit 11 includes an input terminal 110, output terminals 111 to 114, inductor connection terminals 115 and 116, switches S61 to S63, S71, and S72, a power inductor L71 (an example of a first power inductor), and capacitors C61 to C64.

The input terminal 110 is an input terminal for a DC voltage. In other words, the input terminal 110 is a terminal connected to the DC power source 50 to receive an input voltage from the DC power source 50.

The output terminal 111 is an output terminal for the voltage V4. In other words, the output terminal 111 is a terminal for supplying the voltage V4 to the switched-capacitor circuit 20. The output terminal 111 is connected to the external connection terminal 101a of the tracker circuit 1A.

The output terminal 112 is an output terminal for the voltage V3. In other words, the output terminal 112 is a terminal for supplying the voltage V3 to the switched-capacitor circuit 20. The output terminal 112 is connected to the external connection terminal 101b of the tracker circuit 1A. The output terminal 112 is also connected to the power amplifier 2C without passing through the tracker circuit 1A. That is, the pre-regulator circuit 11 is connected to the switched-capacitor circuit 20 and also connected to the power amplifier 2C without passing through the tracker circuit 1A.

The output terminal 113 is an output terminal for the voltage V2. That is, the output terminal 113 is a terminal for supplying the voltage V2 to the switched-capacitor circuit 20. The output terminal 113 is connected to the external connection terminal 101c of the tracker circuit 1A.

The output terminal 114 is an output terminal for the voltage V1. That is, the output terminal 114 is a terminal for supplying the voltage V1 to the switched-capacitor circuit 20. The output terminal 114 is connected to the external connection terminal 101d of the tracker circuit 1A.

The inductor connection terminal 115 is connected to one end of the power inductor L71. The inductor connection terminal 116 is connected to the other end of the power inductor L71.

The switch S71 is connected between the input terminal 110 and one end of the power inductor L71. Specifically, the switch S71 has a terminal connected to the input terminal 110 and a terminal connected to one end of the power inductor L71 through the inductor connection terminal 115. In this connection configuration, the switch S71 can be switched on and off to switch between connection and non-connection between the input terminal 110 and one end of the power inductor L71.

The switch S72 is connected between one end of the power inductor L71 and the ground. Specifically, the switch S72 has a terminal connected to one end of the power inductor L71 through the inductor connection terminal 115 and a terminal connected to the ground. In this connection configuration, the switch S72 can be switched on and off to switch between connection and non-connection between one end of the power inductor L71 and the ground.

The switch S61 is connected between the other end of the power inductor L71 and the output terminal 111. Specifically, the switch S61 has a terminal connected to the other end of the power inductor L71 through the inductor connection terminal 116 and a terminal connected to the output terminal 111. In this connection configuration, the switch S61 can be switched on and off to switch between connection and non-connection between the other end of the power inductor L71 and the output terminal 111.

The switch S62 is connected between the other end of the power inductor L71 and the output terminal 112. Specifically, the switch S62 has a terminal connected to the other end of the power inductor L71 through the inductor connection terminal 116 and a terminal connected to the output terminal 112. In this connection configuration, the switch S62 can be switched on and off to switch between connection and non-connection between the other end of the power inductor L71 and the output terminal 112.

The switch S63 is connected between the other end of the power inductor L71 and the output terminal 113. Specifically, the switch S63 has a terminal connected to the other end of the power inductor L71 through the inductor connection terminal 116 and a terminal connected to the output terminal 113. In this connection configuration, the switch S63 can be switched on and off to switch between connection and non-connection between the other end of the power inductor L71 and the output terminal 113.

One of the two electrodes of the capacitor C61 is connected to the switch S61 and the output terminal 111. The other of the two electrodes of the capacitor C61 is connected to the switch S62, the output terminal 112, and one of the two electrodes of the capacitor C62.

One of the two electrodes of the capacitor C62 is connected to the switch S62, the output terminal 112, and the other of the two electrodes of the capacitor C61. The other of the two electrodes of the capacitor C62 is connected to a path connecting the switch S63, the output terminal 113, and one of the two electrodes of the capacitor C63.

One of the two electrodes of the capacitor C63 is connected to the switch S63, the output terminal 113, and the other of the two electrodes of the capacitor C62. The other of the two electrodes of the capacitor C63 is connected to the output terminal 114 and one of the two electrodes of the capacitor C64.

One of the two electrodes of the capacitor C64 is connected to the output terminal 114 and the other of the two electrodes of the capacitor C63. The other of the two electrodes of the capacitor C64 is connected to the ground.

The switches S61 to S63 are controlled to be exclusively on. In other words, only one of the switches S61 to S63 is turned on, and the rest of the switches S61 to S63 are turned off. By turning on only one of the switches S61 to S63, the pre-regulator circuit 11 can change the voltage supplied to the switched-capacitor circuit 20 between the voltage levels of the voltages V2 to V4.

The pre-regulator circuit 11 thus configured can supply charges to the switched-capacitor circuit 20 through at least one of the output terminals 111 to 113.

When the input voltage is converted into one regulating voltage, the pre-regulator circuit 11 only needs to include at least the switches S71 and S72, the power inductor L71, the input terminal 110, and any one of the output terminals 111 to 114. In this case, the external connection terminals 101a to 101d of the tracker circuit 1A may be replaced with one external connection terminal.

### [1.2.4 Circuit Configuration of Filter Circuit 41]

Next, a circuit configuration of the filter circuit 41 will be described. The filter circuit 41 includes an input terminal 140, output terminals 141 and 142, inductors L51 and L52, a capacitor C51, switches S55 and S56, and voltage supply paths P41 and P42.

The input terminal 140 is connected to the output terminal 130 of the supply modulator 31 outside the filter circuit 41, and connected to the output terminal 141 inside the filter circuit 41.

The output terminal 141 is connected to the external connection terminal 102 of the tracker circuit 1A outside the filter circuit 41, and connected to the input terminal 140 inside the filter circuit 41.

The output terminal 142 is connected to the external connection terminal 103 of the tracker circuit 1A outside the filter circuit 41, and connected to the input terminal 140 inside the filter circuit 41.

The voltage supply path P41 is an example of a first voltage supply path, which is part of the path connecting the supply modulator 31 and the power amplifier 2A. Here, the voltage supply path P41 is a path that directly connects the input terminal 140 and the output terminal 141. That is, in this embodiment, no circuit elements (active elements and passive elements) are connected between the input terminal 140 and the output terminal 141 on the voltage supply path P41. Note that a circuit element may be connected between the input terminal 140 and the output terminal 141 on the voltage supply path P41.

The voltage supply path P42 is an example of a second voltage supply path, which is part of the path connecting the supply modulator 31 and the power amplifier 2B. Here, the voltage supply path P42 is a path connecting the input terminal 140 and the output terminal 142, and partially overlaps with the voltage supply path P41. Note that the voltage supply path P42 does not necessarily have to overlap with the voltage supply path P41.

The inductor L51 is an example of a first inductor, which is connected in series to the capacitor C51. Specifically, one end of the inductor L51 is connected to a path between the switch S55 and the inductor L52 in the voltage supply path P42, and the other end of the inductor L51 is connected to the capacitor C51.

The capacitor C51 is an example of a first capacitor, which is connected between the inductor L51 and the ground. Specifically, one end of the capacitor C51 is connected to the inductor L51, and the other end of the capacitor C51 is connected to the ground.

The inductor L52 is an example of a second inductor, which is connected between the input terminal 140 and the output terminal 142 on the voltage supply path P42. Specifically, one end of the inductor L52 is connected to the switch S55 and the inductor L51, and the other end of the inductor L52 is connected to the switch S56 and the output terminal 142.

The switch S55 is an example of a third switch, which is connected between the voltage supply path P41 and the inductors L51 and L52. Specifically, one end of the switch S55 is connected to the voltage supply path P41, and the other end of the switch S55 is connected to the inductors L51 and L52.

The switch S56 is an example of a fourth switch, which is connected between the voltage supply paths P41 and P42. Specifically, one end of the switch S56 is connected to the voltage supply path P41, and the other end of the switch S56 is connected to a path between the inductor L52 and the output terminal 142 in the voltage supply path P42.

The switches S55 and S56 thus connected are switched on and off based on the control signal S4 to function as a variable band elimination filter. For example, by closing the switch S55 and opening the switch S56, the inductor L51 and the capacitor C51 are connected between the voltage supply path P41 and the ground. This allows the filter circuit 41 to function as a band elimination filter having a first stopband on the voltage supply path P41. On the other hand, by opening the switch S55 and closing the switch S56, for example, the inductors L51 and L52 and the capacitor C51 are connected between the voltage supply path P41 and the ground. This allows the filter circuit 41 to function as a band elimination filter having a second stopband different from the first stopband on the voltage supply path P41. Such on and off of the switches S55 and S56 can be controlled based on a channel band width (that is, modulation band width) of an RF signal, for example.

The control of the switches S55 and S56 described above is merely an example, and the present invention is not limited to the above description. For example, when each of the power amplifiers 2A and 2B selectively amplifies transmission signals of a plurality of bands, the on and off of the switches S55 and S56 may be controlled according to the band of the transmission signal to be amplified.

### [1.2.5 Circuit Configuration of Digital Control Circuit 60]

Next, a circuit configuration of the digital control circuit 60 included in the tracker circuit 1A will be described. As illustrated in Fig. 4, the digital control circuit 60 includes a first controller 61, a second controller 62, capacitors C81 and C82, and control terminals 601 to 604.

The first controller 61 can process source-synchronous digital control signals received from the RFIC 5 through the control terminals 601 and 602 to generate the control signals S2 and S4. The control signal S2 is a signal for controlling on and off of the switches S11 to S14, S21 to S24, S31 to S34, and S41 to S44 included in the switched-capacitor circuit 20. The control signal S4 is a signal for controlling on and off of the switch S55 included in the filter circuit 41.

The digital control signal processed by the first controller 61 is not limited to the source-synchronous digital control signal. For example, the first controller 61 may process a clock-embedded digital control signal. The first controller 61 may also generate a control signal for controlling the supply modulator 31.

In this embodiment, a set of clock signals and data signals are used as the digital control signals for the pre-regulator circuit 11, the switched-capacitor circuit 20, and the filter circuit 41. However, the present invention is not limited thereto. For example, sets of clock signals and data signals may be used individually as the digital control signals for the pre-regulator circuit 11, the switched-capacitor circuit 20, and the filter circuit 41.

The second controller 62 processes a digital control logic/line (DCL) signals (DCL1 and DCL2) received from the RFIC 5 through the control terminals 603 and 604 to generate the control signal S3. The DCL signals (DCL1 and DCL2) are generated by the RFIC 5 based on an envelope signal of an RF signal or the like. The control signal S3 is a signal for controlling on and off of the switches S51 to S54 included in the supply modulator 31.

The DCL signals (DCL1 and DCL2) are each a 1-bit signal. The voltages V1 to V4 are each represented by a combination of two 1-bit signals. For example, V1, V2, V3, and V4 are represented by "00", "01", "10", and "11", respectively. The gray code may be used to represent the voltage levels.

The capacitor C81 is connected between the first controller 61 and the ground. For example, the capacitor C81 is connected between a power supply line that supplies power to the first controller 61 and the ground, and functions as a bypass capacitor. The capacitor C82 is connected between the second controller 62 and the ground.

In this embodiment, two digitally controlled level (DCL) signals are used to control the supply modulator 31. However, the number of DCL signals is not limited thereto. For example, one or any number of DCL signals, such as greater than or equal to three, may be used depending on the number of voltage levels that can be selected by each supply modulator 31. The digital control signal used to control the supply modulator 31 is not limited to the DCL signal.

### [1.3 Tracking Method]

Next, a tracking method will be described with reference to Fig. 5, which is a method of supplying a plurality of discrete voltages in the communication device 7A configured as described above. Fig. 5 is a flowchart illustrating the tracking method according to this embodiment. Specifically, Fig. 5 is a flowchart illustrating a tracking method when the band A or B is used for communication.

Note that Fig. 5 is an exemplary flowchart, and the tracking method is not limited to the steps and the order of steps in Fig. 5. Therefore, the description of the tracking method provided below should not be interpreted as being limited thereto.

For example, the RFIC 5 determines whether to use the digital ET mode or the APT mode to amplify the RF signal RF_{A} or RF_{B} of the band A or B (S101). For example, it is determined that the digital ET mode is to be used when the first power class is applied to the RF signal RF_{A} or RF_{B} of the band A or B. It is determined, on the other hand, that the APT mode is to be used when the second power class is applied to the RF signal RF_{A} or RF_{B} of the band A or B.

When it is determined here that the digital ET mode is to be used (D-ET in S101), the switch S66 is opened and the bypass path BP1 is disconnected (S103). The switched-capacitor circuit 20 generates a plurality of discrete voltages based on the regulating voltage received from the pre-regulator circuit 11 (S105). The supply modulator 31 selectively outputs at least one of the plurality of discrete voltages to the power amplifier 2A or 2B, based on the envelope of the RF signal RF_{A} or RF_{B} (S107). This causes a power supply voltage V_{T1} or V_{T2}, which changes in a plurality of discrete levels over time according to the envelope of the RF signal RF_{A} or RF_{B}, to be supplied to the power amplifier 2A or 2B. This allows the power amplifier 2A or 2B to amplify the RF signal RF_{A} or RF_{B} using the power supply voltage V_{T1} or V_{T2} corresponding to the envelope of the RF signal RF_{A} or RF_{B}. That is, the power amplifier 2A or 2B can amplify the RF signal RF_{A} or RF_{B} in the digital ET mode.

When it is determined, on the other hand, that the APT mode is to be used (APT in S101), the switch S66 is closed and the bypass path BP1 is connected (S109). The tracker circuit 1A outputs the regulating voltage received from the pre-regulator circuit 11 to the power amplifier 2A or 2B through the filter circuit 41 (S111). This causes a power supply voltage V_{T1} or V_{T2} , which changes in a plurality of discrete levels on a frame-by-frame basis, for example, according to the average power, to be supplied to the power amplifier 2A or 2B. This allows the power amplifier 2A or 2B to amplify the RF signal RF_{A} or RF_{B} using the power supply voltage V_{T1} or V_{T2} corresponding to the average power of the RF signal RF_{A} or RF_{B}. That is, the power amplifier 2A or 2B can amplify the RF signal RF_{A} or RF_{B} in the APT mode.

When the band C is used for communication, the pre-regulator circuit 11 converts the input voltage into a regulating voltage based on the average power of the RF signal RF_{C} and outputs the regulating voltage to the power amplifier 2C. This causes a power supply voltage V_{T3} which changes in a plurality of discrete levels on a frame-by-frame basis, for example, according to the average power, to be supplied to the power amplifier 2C. This allows the power amplifier 2C to amplify the RF signal RF_{C} using the power supply voltage V_{T3} corresponding to the average power of the RF signal RF_{C}. That is, the power amplifier 2C can amplify the RF signal RF_{C} in the APT mode.

### [1.4 Mounting Example of Tracker Circuit 1A]

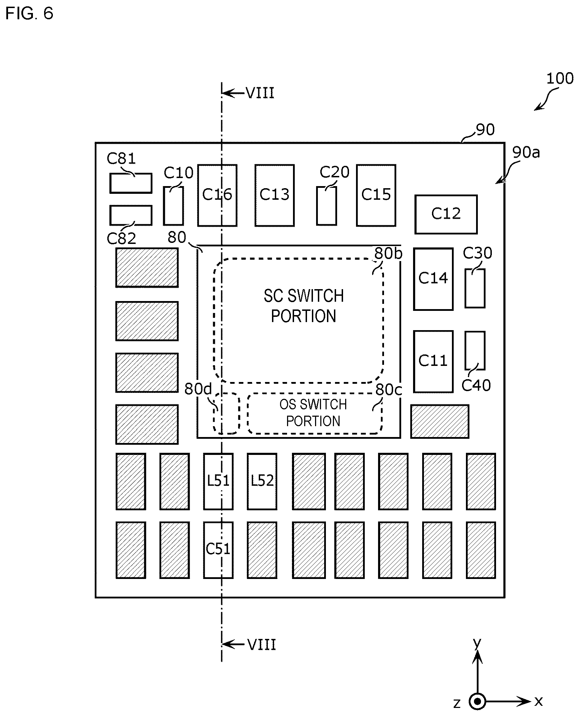

Next, with reference to Figs. 6 to 8, a tracker module 100 will be described as a mounting example of the tracker circuit 1A configured as described above.

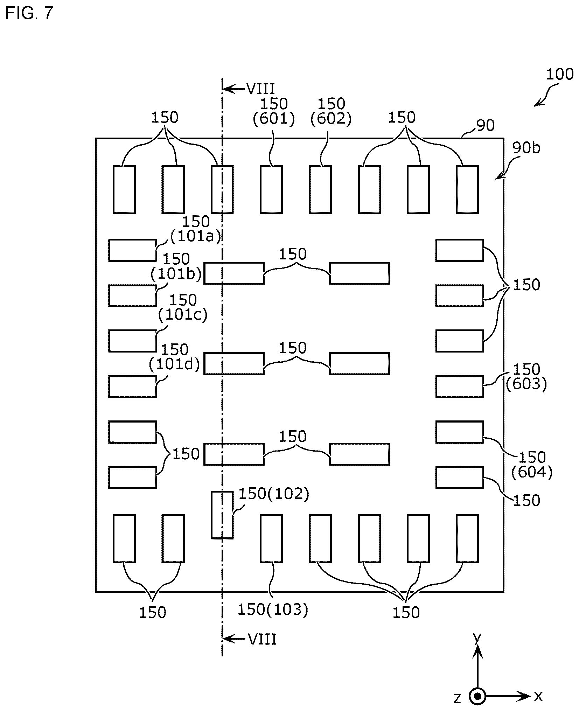

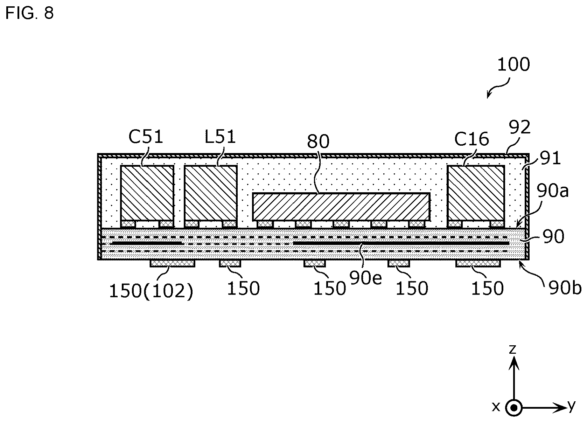

Fig. 6 is a plan view of the tracker module 100 according to this embodiment. Fig. 7 is a plan view of the tracker module 100 according to this embodiment, seen through the main surface 90b side of a module laminate 90 from the positive side of the z-axis. Fig. 8 is a cross-sectional view of the tracker module 100 according to this embodiment. The cross-section of the tracker module 100 in Fig. 8 is taken along line VIII-VIII in Figs. 6 and 7.

In Figs. 6 to 8, some of the wiring connecting a plurality of circuit components arranged on the module laminate 90 is omitted. In Figs. 6 and 7, a resin member 91 covering the plurality of circuit components and a shield electrode layer 92 covering the surface of the resin member 91 are omitted. In Fig. 6, hatched blocks represent optional circuit components that are not essential to the present invention.

The tracker module 100 includes the module laminate 90, the resin member 91, the shield electrode layer 92, and a plurality of electrodes 150, in addition to the plurality of circuit components including the switched-capacitor circuit 20, the supply modulator 31, the filter circuit 41, and the active and passive elements included in the digital control circuit 60 illustrated in Figs. 3 and 4.

The module laminate 90 has main surfaces 90a and 90b facing each other. A ground plane 90e and the like are formed within the module laminate 90 and on the main surface 90a. The module laminate 90 has a rectangular shape in plan view of Figs. 6 and 7, but the present invention is not limited to this shape.

The module laminate 90 may be, but not limited to, for example, a low temperature co-fired ceramics (LTCC) board or high temperature co-fired ceramics (HTCC) board having a laminate structure of a plurality of dielectric layers, a component-embedded board, a board having a redistribution layer (RDL), a printed circuit board or the like.

On the main surface 90a, an integrated circuit 80, capacitors C10 to C16, C20, C30, C40, C51, C81, and C82, an inductor L51, and the resin member 91 are arranged.

The integrated circuit 80 includes an SC switch portion 80b, an OS switch portion 80c, and a filter switch portion 80d. The SC switch portion 80b includes switches S11 to S14, S21 to S24, S31 to S34, and S41 to S44. The OS switch portion 80c includes switches S51 to S54. The filter switch portion 80d includes a switch S55.

While the SC switch portion 80b, the OS switch portion 80c, and the filter switch portion 80d are included in the single integrated circuit 80 in Fig. 6, the present invention is not limited thereto. For example, the SC switch portion 80b may be included in one integrated circuit, and the OS switch portion 80c and the filter switch portion 80d may be included in another integrated circuit. Alternatively, the SC switch portion 80b, the OS switch portion 80c, and the filter switch portion 80d may be included in three separate integrated circuits.

The integrated circuit 80 has a rectangular shape in plan view of the module laminate 90 in Fig. 6, but the present invention is not limited to this shape.

The integrated circuit 80 is configured using a complementary metal oxide semiconductor (CMOS), for example. Specifically, the integrated circuit 80 may be manufactured by a silicon on insulator (SOI) process. The integrated circuit 80 is not limited to the CMOS.

The capacitors C10 to C16, C20, C30, C40, C51, C81, and C82 are each mounted as a chip capacitor. The chip capacitor refers to a surface mount device (SMD) that constitutes a capacitor. Note that the plurality of capacitors to be mounted are not limited to the chip capacitors. For example, some or all of the plurality of capacitors may be included in an integrated passive device (IPD) or may be included in the integrated circuit 80.

The inductors L51 and L52 are mounted as chip inductors. The chip inductor refers to an SMD that constitutes an inductor. Note that the inductors L51 and L52 to be mounted are not limited to the chip inductors. For example, the inductors L51 and L52 may be included in an IPD.

The plurality of capacitors and inductors thus arranged on the main surface 90a are grouped by circuit and arranged around the integrated circuit 80.

The group including the capacitors C10 to C16, C20, C30, and C40 included in the switched-capacitor circuit 20 is disposed in a region on the main surface 90a sandwiched between a straight line along the top side of the integrated circuit 80 and a straight line along the top side of the module laminate 90, and in a region on the main surface 90a sandwiched between a straight line along the right side of the integrated circuit 80 and a straight line along the right side of the module laminate 90, in plan view of the module laminate 90. This allows the group of circuit components included in the switched-capacitor circuit 20 to be disposed near the SC switch portion 80b in the integrated circuit 80. That is, the SC switch portion 80b is disposed closer to the switched-capacitor circuit 20 than the OS switch portion 80c.

The group including the capacitor C51 and the inductors L51 and L52 included in the filter circuit 41 is disposed in a region on the main surface 90a sandwiched between a straight line along the bottom side of the integrated circuit 80 and a straight line along the bottom side of the module laminate 90 in plan view of the module laminate 90. This allows the group of circuit components included in the filter circuit 41 to be disposed near the filter switch portion 80d in the integrated circuit 80. That is, the filter switch portion 80d is disposed closer to the capacitor C51 and the inductors L51 and L52 in the filter circuit 41 than the SC switch portion 80b.

The plurality of electrodes 150 are arranged on the main surface 90b. Some of the plurality of electrodes 150 function as the external connection terminals 101a to 101d, 102, and 103 illustrated in Fig. 2. The plurality of electrodes 150 are electrically connected to a plurality of electronic components arranged on the main surface 90a through via conductors or the like formed in the module laminate 90. The plurality of electrodes 150 may be, but not limited to, copper electrodes. For example, the plurality of electrodes may be solder electrodes.

The resin member 91 covers the main surface 90a and at least some of the plurality of electronic components on the main surface 90a. The resin member 91 has a function to ensure the reliability of the plurality of electronic components on the main surface 90a, such as mechanical strength and moisture resistance. The resin member 91 does not have to be included in the tracker module 100.

The shield electrode layer 92 is a metal thin film formed by a sputtering method, for example. The shield electrode layer 92 is formed so as to cover the surface (top and side) of the resin member 91. The shield electrode layer 92 is connected to the ground and prevents external noise from entering the electronic components included in the tracker module 100, and also prevents noise generated in the tracker module 100 from interfering with other modules or other devices. The shield electrode layer 92 does not have to be included in the tracker module 100.

Note that the configuration of the tracker module 100 illustrated in Figs. 6 to 8 is merely an example, and the present invention is not limited to this example. For example, some of the capacitors and inductors arranged on the main surface 90a may be formed in the module laminate 90. Moreover, some of the capacitors and inductors arranged on the main surface 90a do not have to be included in the tracker module 100, and do not have to be arranged on the module laminate 90.

### [1.5 Example of Module Layout in Communication Device 7A]

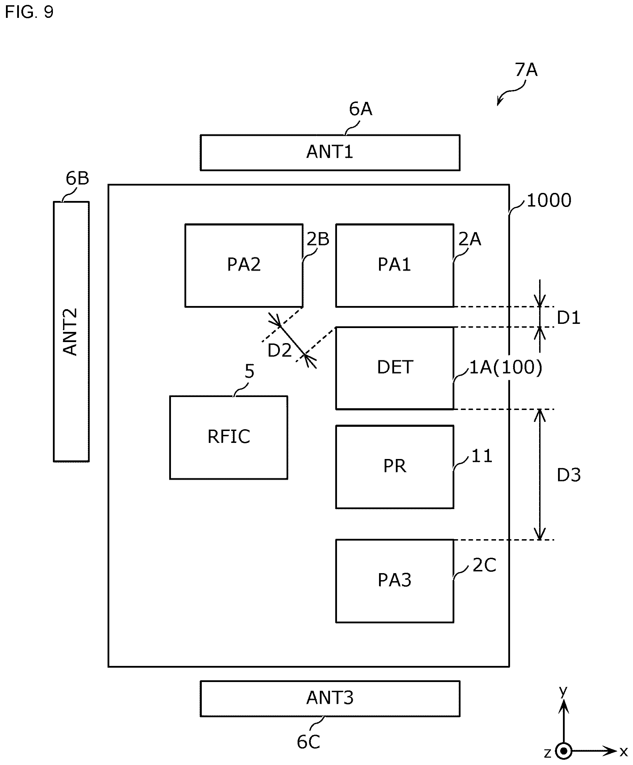

Next, a mounting example of the communication device 7A will be described with reference to Fig. 9. Fig. 9 is a layout diagram of modules in the communication device 7A according to this embodiment. In Fig. 9, each module is denoted by an abbreviation (such as "PA1") that indicates its function, so that the layout relationship between the modules can be easily understood, but the actual modules do not need to be denoted by such abbreviations.

On a motherboard 1000, the tracker module 100 (DET) including the tracker circuit 1A, PA modules (PA1 to PA3) including power amplifiers 2A to 2C, respectively, the RFIC 5, and a PR module (PR) including the pre-regulator circuit 11 are arranged.

The PA module (PA1) including the power amplifier 2A may include a filter 3A, the PA module (PA2) including the power amplifier 2B may include a filter 3B, and the PA module (PA3) including the power amplifier 2C may include a filter 3C.

In plan view of the motherboard 1000, the tracker module 100 (DET) is disposed between the PR module (PR) and the PA module (PA1). The tracker module 100 (DET) is also disposed near the PA modules (PA1 and PA2). That is, in plan view of the motherboard 1000, a distance D1 between the tracker module 100 (DET) and the PA module (PA1) is shorter than a distance D3 between the tracker module 100 (DET) and the PA module (PA3). Furthermore, in plan view of the motherboard 1000, a distance D2 between the tracker module 100 (DET) and the PA module (PA2) is shorter than the distance D3 between the tracker module 100 (DET) and the PA module (PA3).

The antenna 6A (ANT1) is disposed on the top side of the motherboard 1000 and is disposed near the PA module (PA1) including the power amplifier 2A. The antenna 6B (ANT2) is disposed on the left side of the motherboard 1000 and is disposed near the PA module (PA2) including the power amplifier 2B. The antenna 6C (ANT3) is disposed on the bottom side of the motherboard 1000 and is disposed near the PA module (PA3) including the power amplifier 2C.

### [1.6 Effects and the like]

As described above, the tracker circuit 1A according to this embodiment includes: the switched-capacitor circuit 20 configured to generate a plurality of discrete voltages based on the first input voltage; the supply modulator 31 configured to selectively output at least one of the plurality of discrete voltages to the power amplifier 2A; the bypass path BP1 configured to bypass the switched-capacitor circuit 20 and the supply modulator 31 and output the first input voltage to the power amplifier 2A; and the switch S66 configured to switch between connection and disconnection of the bypass path BP1.

From another perspective, the tracker circuit 1A according to this embodiment includes: the external connection terminal 101 for receiving the first input voltage; the external connection terminal 102 connected to the power amplifier 2A; the switched-capacitor circuit 20 including the input terminal 120 connected to the external connection terminal 101 and the output terminals 121 to 124; the supply modulator 31 including the input terminals 131 to 134 connected to the output terminals 121 to 124, respectively, and the output terminal 130 connected to the external connection terminal 102; the bypass path BP1 connecting between the external connection terminals 101 and 102 without passing through the switched-capacitor circuit 20 and the supply modulator 31; and the switch S66 connected between the external connection terminals 101 and 102 on the bypass path BP1.

With the above configuration, by the switch S66 switching between connection and disconnection of the bypass path BP1, the power supply voltage supplied to the power amplifier 2A can be switched between the plurality of discrete voltages and the first input voltage. When the plurality of discrete voltages are supplied to the power amplifier 2A, the level of the power supply voltage can be discretely and relatively quickly changed by the switched-capacitor circuit 20 and the supply modulator 31. Therefore, the power supply voltage supplied to the power amplifier 2A can be finely regulated according to the RF signal, making it possible to improve the power-added efficiency. In the case of supplying the first input voltage to the power amplifier 2A, on the other hand, the first input voltage can be supplied to the power amplifier 2A without passing through the switched-capacitor circuit 20 and the supply modulator 31. Therefore, loss in the switched-capacitor circuit 20 and the supply modulator 31 can be reduced, making it possible to improve the power-added efficiency. By switching between connection and disconnection of the bypass path BP1, a power supply voltage that provides higher power-added efficiency can be supplied to the power amplifier 2A, making it possible to more effectively improve the power-added efficiency.

For example, in the tracker circuit 1A according to this embodiment, when the first power class is applied to the RF signal amplified by the power amplifier 2A, the switch S66 may disconnect the bypass path BP1. On the other hand, when the second power class is applied to the RF signal amplified by the power amplifier 2A, the switch S66 may connect the bypass path BP1. The first power class may allow maximum output power higher than the second power class.

Accordingly, in the first power class that allows higher maximum output power, the power-added efficiency can be further improved by supplying the plurality of discrete voltages to the power amplifier 2A. In the second power class, on the other hand, that is limited to lower maximum output power and cannot expect much improvement in power-added efficiency by supplying the plurality of discrete voltages, the loss in the switched-capacitor circuit 20 and the supply modulator 31 can be reduced by supplying the first input voltage to the power amplifier 2A.

For example, the tracker circuit 1A according to this embodiment may further include a filter circuit 41 connected between the supply modulator 31 and the power amplifier 2A (external connection terminal 102).

This allows the filter circuit 41 to reduce noise components in the power supply voltage supplied to the power amplifier 2A, thus making it possible to reduce distortion in the power amplifier 2A.

Furthermore, in the tracker circuit 1A according to this embodiment, for example, the supply modulator 31 may also be configured to selectively output at least one of the plurality of discrete voltages to the power amplifier 2B. The filter circuit 41 may also be connected between the supply modulator 31 and the power amplifier 2B.

From another perspective, in the tracker circuit 1A according to this embodiment, the supply modulator 31 may further include an external connection terminal 103 connected to the power amplifier 2B. The filter circuit 41 may also be connected between the supply modulator 31 and the external connection terminal 103.

This allows the tracker circuit 1A to supply a plurality of discrete voltages to the plurality of power amplifiers 2A and 2B. Furthermore, the filter circuit 41 can reduce noise components in the power supply voltage supplied to the power amplifier 2B, making it possible to reduce distortion in the power amplifier 2B.

Furthermore, for example, in the tracker circuit 1A according to this embodiment, the bypass path BP1 may also be configured to output the first input voltage to the power amplifier 2B.

From another perspective, in the tracker circuit 1A according to this embodiment, the bypass path BP1 may further connect between the external connection terminals 101 and 103 without passing through the switched-capacitor circuit 20 and the supply modulator 31.

This allows the first input voltage to be supplied to the two power amplifiers 2A and 2B through the bypass path BP1 that bypasses the switched-capacitor circuit 20 and the supply modulator 31. This makes it possible to reduce the number of bypass paths and the switches on the bypass paths, compared to the case where a bypass path is provided for each of the power amplifiers 2A and 2B, which can contribute to the size reduction of the tracker circuit 1A.

In the tracker circuit 1A according to this embodiment, the filter circuit 41 may include the inductors L51 and L52, the capacitor C51, and the switches S55 and S56. One end of the switch S55 may be connected to the voltage supply path P41 connecting the supply modulator 31 and the power amplifier 2A (external connection terminal 102). The other end of the switch S55 may be connected to the inductors L51 and L52. One end of the switch S56 may be connected to the voltage supply path P41. The other end of the switch S56 may be connected to the path between the inductor L52 and the power amplifier 2B (external connection terminal 103) in the voltage supply path P42 connecting the supply modulator 31 and the power amplifier 2B (external connection terminal 103). One end of the inductor L51 may be connected to the path between the switch S55 and the inductor L52 in the voltage supply path P42. The other end of the inductor L51 may be connected to the capacitor C51. One end of the capacitor C51 may be connected to the inductor L51, and the other end of the capacitor C51 may be connected to the ground. One end of the inductor L52 may be connected to the switch S55 and the inductor L51. The other end of the inductor L52 may be connected to the switch S56 and the power amplifier 2B (external connection terminal 103).

This makes it possible to change the stopband by switching on and off of the switches S55 and S56, and to more effectively reduce the noise components. Since the circuit elements (active elements and passive elements) do not need to be connected in series to the voltage supply path P41, the loss of the power supply voltage supplied to the power amplifier 2A can be suppressed.

In the tracker circuit 1A according to this embodiment, the switched-capacitor circuit 20 may be connected to the pre-regulator circuit 11 configured to convert the voltage from the DC power source into the first input voltage. The pre-regulator circuit 11 may be configured to output the first input voltage to the switched-capacitor circuit 20 and to output the first input voltage to the power amplifier 2C without passing through the switched-capacitor circuit 20.

This allows the first input voltage to be supplied to the power amplifier 2C directly from the pre-regulator circuit 11. This makes it possible to avoid the loss in the tracker circuit 1A, and to improve the power-added efficiency of the power amplifier 2C that does not need to have a plurality of discrete voltages supplied from the switched-capacitor circuit 20 and the supply modulator 31.

Furthermore, the tracking method according to this embodiment includes, in the case of operating the power amplifier 2A or 2B in the digital ET mode, (i) disconnecting the bypass path BP1 connecting between the external connection terminals 101 and 102, (ii) generating a plurality of discrete voltages based on the input voltage received through the external connection terminal 101, and (iii) selectively supplying at least one of the plurality of discrete voltages to the power amplifier 2A or 2B through the external connection terminal 102 based on the envelope of the RF signal amplified by the power amplifier 2A or 2B. On the other hand, the tracking method according to this embodiment includes, in the case of operating the power amplifier 2A or 2B in the APT mode, (i) connecting the bypass path BP1, and (ii) supplying the input voltage received through the external connection terminal 101 to the power amplifier 2A or 2B through the bypass path BP1 and the external connection terminal 102.

This allows the power amplifier 2A or 2B to operate in the digital ET mode and the APT mode, making it possible to more effectively improve the power-added efficiency. Furthermore, in the case of operating in the APT mode, the bypass path BP1 can be connected to skip the generation of the plurality of discrete voltages and the selective supply of at least one of the plurality of discrete voltages. This makes it possible to reduce the power loss due to the switched-capacitor circuit 20, the supply modulator 31, and the like.

### (Modification of Embodiment 1)

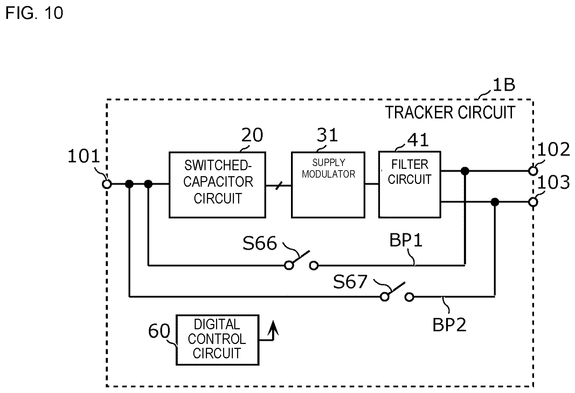

Next, a modification of Embodiment 1 will be described. A tracker circuit 1B according to this modification is mainly different from the tracker circuit 1A according to Embodiment 1 in the configuration of the bypass path. The tracker circuit 1B according to this embodiment will be described below with reference to Fig. 10, focusing on differences from the tracker circuit 1A according to Embodiment 1.

### [1.7 Circuit Configuration of Tracker Circuit 1B]

Fig. 10 is a circuit configuration diagram of the tracker circuit 1B according to this modification. Note that Fig. 10 illustrates an exemplary circuit configuration, and the tracker circuit 1B may be implemented using any of a wide variety of circuit implementations and circuit technologies. Therefore, the description of the tracker circuit 1B provided below should not be interpreted as being limited thereto.

The tracker circuit 1B includes a switched-capacitor circuit 20, a supply modulator 31, a filter circuit 41, a digital control circuit 60, external connection terminals 101 to 103, bypass paths BP1 and BP2, and switches S66 and S67.

The bypass path BP1 is an example of a first bypass path, and is configured to bypass the switched-capacitor circuit 20 and the supply modulator 31 and output a regulating voltage from a pre-regulator circuit 11 to a power amplifier 2A. Specifically, the bypass path BP1 connects between the external connection terminals 101 and 102 without passing through the switched-capacitor circuit 20, the supply modulator 31, and the filter circuit 41.

The bypass path BP2 is an example of a second bypass path, and is configured to bypass the switched-capacitor circuit 20 and the supply modulator 31, and output the regulating voltage from the pre-regulator circuit 11 to a power amplifier 2B. Specifically, the bypass path BP2 connects between the external connection terminals 101 and 103 without passing through the switched-capacitor circuit 20, the supply modulator 31, and the filter circuit 41.

The switch S66 is an example of a first switch, and is configured to switch between connection and disconnection of the bypass path BP1. Specifically, the switch S66 is connected between the external connection terminals 101 and 102 on the bypass path BP1. That is, one end of the switch S66 is connected to the external connection terminal 101, and the other end of the switch S66 is connected directly to the external connection terminal 102.

The switch S67 is an example of a second switch, and is configured to switch between connection and disconnection of the bypass path BP2. Specifically, the switch S67 is connected between the external connection terminals 101 and 103 on the bypass path BP2. That is, one end of the switch S67 is connected to the external connection terminal 101, and the other end of the switch S67 is connected directly to the external connection terminal 103.

The switches S66 and S67 thus connected are switched on and off based on a control signal S4. For example, on and off of the switches S66 and S67 is controlled as follows. (1) When an RF signal RF_{A} is transmitted in a first power class, the switches S66 and S67 are opened. That is, the bypass paths BP1 and BP2 are disconnected, and the regulating voltage received through the external connection terminal 101 is supplied to the switched-capacitor circuit 20. As a result, a plurality of discrete voltages are generated in the switched-capacitor circuit 20, and the supply modulator 31 selectively outputs at least one of the plurality of discrete voltages to the external connection terminal 102. This causes the power amplifier 2A to operate in the digital ET mode. (2) When the RF signal RF_{A} is transmitted in a second power class, the switch S66 is closed and the switch S67 is opened. That is, the bypass path BP1 is connected, and the regulating voltage received through the external connection terminal 101 is outputted to the external connection terminal 102. This causes the power amplifier 2A to operate in the APT mode. (3) When an RF signal RF_{B} is transmitted in the first power class, the switches S66 and S67 are opened. That is, the bypass paths BP1 and BP2 are disconnected, and the regulating voltage received through the external connection terminal 101 is supplied to the switched-capacitor circuit 20. As a result, a plurality of discrete voltages are generated in the switched-capacitor circuit 20, and the supply modulator 31 selectively outputs at least one of the plurality of discrete voltages to the external connection terminal 103. This causes the power amplifier 2B to operate in the digital ET mode. (4) When the RF signal RF_{B} is transmitted in the second power class, the switch S66 is opened and the switch S67 is closed. That is, the bypass path BP2 is connected, and the regulating voltage received through the external connection terminal 101 is outputted to the external connection terminal 103. This causes the power amplifier 2B to operate in the APT mode.

### [1.8 Effects and the like]

As described above, the tracker circuit 1B according to this modification may further include the bypass path BP2 configured to bypass the switched-capacitor circuit 20 and the supply modulator 31 and output the first input voltage to the power amplifier 2B, and the switch S67 configured to switch between connection and non-connection of the bypass path BP2.

From another perspective, the tracker circuit 1B according to this modification may further include the bypass path BP2 that connects between the external connection terminals 101 and 103 without passing through the switched-capacitor circuit 20 and the supply modulator 31, and the switch S67 connected between the external connection terminals 101 and 103 on the bypass path BP2.

This allows the first input voltage to be supplied to the power amplifier 2B through the bypass path BP2. In this event, by the switch S67 switching between connection and disconnection of the bypass path BP2, the power supply voltage supplied to the power amplifier 2B can be switched between the plurality of discrete voltages and the first input voltage. This makes it possible to more effectively improve the power-added efficiency.

### (Embodiment 2)

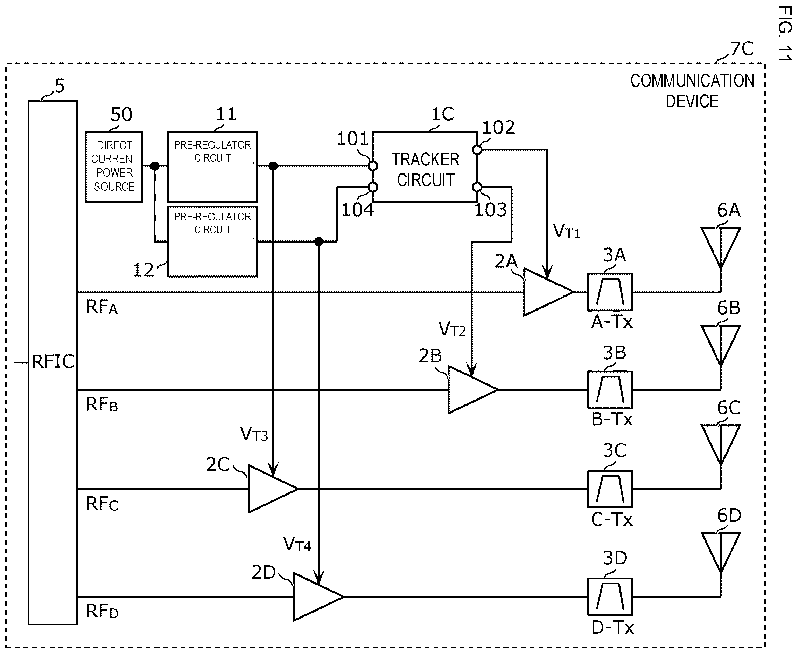

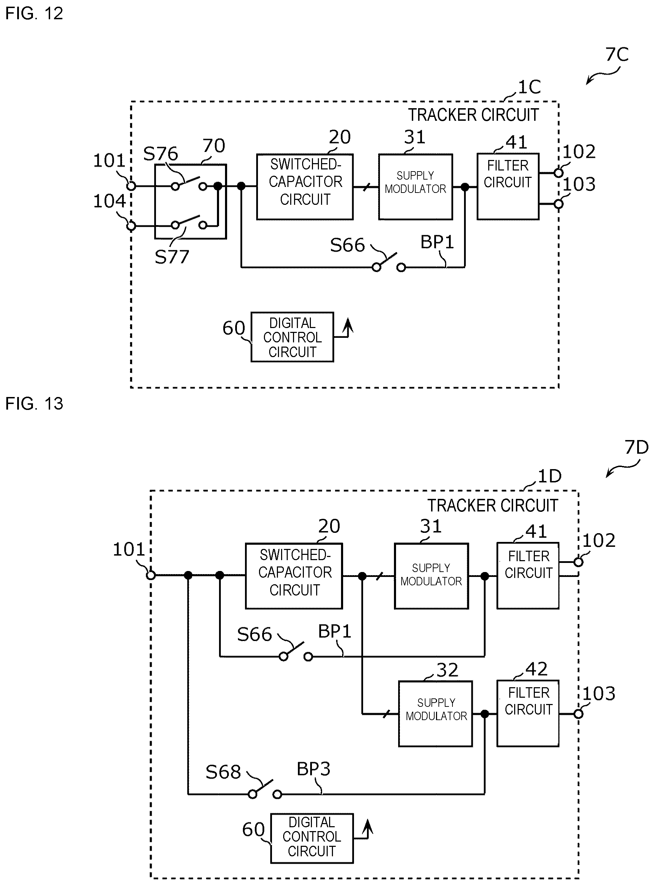

Next, Embodiment 2 will be described. A tracker circuit 1C according to this embodiment is mainly different from the tracker circuit 1A according to Embodiment 1 in that the tracker circuit 1C can selectively connect to a plurality of pre-regulator circuits. The tracker circuit 1C according to this embodiment will be described below with reference to Figs. 11 and 12, focusing on the differences from the tracker circuit 1A according to Embodiment 1. Fig. 11 is a circuit configuration diagram of a communication device 7C according to this embodiment. Fig. 12 is a circuit configuration diagram of the tracker circuit 1C according to this embodiment.

Note that Figs. 11 and 12 illustrate exemplary circuit configurations, and the communication device 7C and the tracker circuit 1C can be implemented using any of a wide variety of circuit implementations and circuit technologies. Therefore, the following description of the communication device 7C and the tracker circuit 1C should not be interpreted as being limited thereto.

### [2.1 Circuit Configuration of Communication Device 7C]

First, a circuit configuration of the communication device 7C according to this embodiment will be described with reference to Fig. 11. The communication device 7C includes the tracker circuit 1C, power amplifiers 2A to 2D, filters 3A to 3D, an RFIC 5, antennas 6A to 6D, pre-regulator circuits 11 and 12, and a DC power source 50.

The pre-regulator circuit 12 is an example of a third converter circuit, which is configured to convert a voltage from the DC power source 50 into a regulating voltage (an example of a second input voltage). The pre-regulator circuit 12 can output the regulating voltage to the switched-capacitor circuit 20, and can also output the regulating voltage to the power amplifier 2D without passing through the switched-capacitor circuit 20.

The power amplifier 2D is connected between the RFIC 5 and the filter 3D. The power amplifier 2D is also connected to the pre-regulator circuit 12, and can receive a power supply voltage V_{T4} based on the APT mode from the pre-regulator circuit 12. The power amplifier 2D can use the power supply voltage V_{T4} received from the pre-regulator circuit 12 to amplify an RF signal RF_{D} of a band D received from the RFIC 5. That is, the power amplifier 2D can operate in the APT mode. Note that the power amplifier 2D does not have to be included in the communication device 7C.

The filter 3D is connected between the power amplifier 2D and the antenna 6D. The filter 3D is a band pass filter having a passband including the transmission band of the band D. Note that the filter 3D does not have to be included in the communication device 7C.

As with the bands A to C, the band D is a frequency band for a communication system built using a RAT, and is predefined by a standardizing body or the like. A frequency band included in the mid-high band group (1427 to 2690 MHz) or the low band group (698 to 960 MHz), for example, is used as the band D. Note that the band D is not limited to the frequency band included in the mid-high band group or low band group.

The antenna 6D outputs a transmission signal of the band D inputted from the power amplifier 2D through the filter 3D. The antenna 6D does not have to be included in the communication device 7C.

### [2.2 Circuit Configuration of Tracker Circuit 1C]

Next, a circuit configuration of the tracker circuit 1C will be described with reference to Fig. 12. The tracker circuit 1C includes the switched-capacitor circuit 20, a supply modulator 31, a filter circuit 41, a digital control circuit 60, an input switch circuit 70, external connection terminals 101 to 104, a bypass path BP1, and a switch S66.

The external connection terminal 101 is an example of a first external connection terminal, which is connected to the pre-regulator circuit 11 outside the tracker circuit 1C and is connected to the input switch circuit 70 inside the tracker circuit 1C.

The external connection terminal 102 is an example of a second external connection terminal, which is connected to the power amplifier 2A outside the tracker circuit 1C and is connected to the filter circuit 41 inside the tracker circuit 1C. The external connection terminal 102 is a terminal for supplying a power supply voltage V_{T1} to the power amplifier 2A.

The external connection terminal 103 is an example of a third external connection terminal, which is connected to the power amplifier 2B outside the tracker circuit 1C and is connected to the filter circuit 41 inside the tracker circuit 1C. The external connection terminal 103 is a terminal for supplying a power supply voltage V_{T2} to the power amplifier 2B. The external connection terminal 103 does not have to be included in the tracker circuit 1C.

As with the external connection terminal 101, the external connection terminal 104 is a terminal that represents a plurality of external connection terminals. The external connection terminal 104 is connected to the pre-regulator circuit 12 outside the tracker circuit 1C and is connected to the input switch circuit 70 inside the tracker circuit 1C. The external connection terminal 104 is a terminal for receiving a regulating voltage (an example of a second input voltage) from the pre-regulator circuit 12.

The input switch circuit 70 is configured to switch the connection of the switched-capacitor circuit 20 between the pre-regulator circuits 11 and 12. For example, the input switch circuit 70 can be configured as a single-pole double-throw (SPDT) type switch circuit. Specifically, the input switch circuit 70 includes switches S76 and S77.

The switch S76 is connected between the external connection terminal 101 and an input terminal of the switched-capacitor circuit 20. That is, one end of the switch S76 is connected to the external connection terminal 101, and the other end of the switch S76 is connected to the input terminal of the switched-capacitor circuit 20.

The switch S77 is connected between the external connection terminal 104 and the input terminal of the switched-capacitor circuit 20. That is, one end of the switch S77 is connected to the external connection terminal 104, and the other end of the switch S77 is connected to the input terminal of the switched-capacitor circuit 20.

### [2.3 Effects and the like]

As described above, in the tracker circuit 1C according to this embodiment, the switched-capacitor circuit 20 may be further connected to the pre-regulator circuit 12 configured to convert the voltage from the DC power source 50 into the second input voltage. The switched-capacitor circuit 20 may also be configured to generate a plurality of discrete voltages based on the second input voltage. The tracker circuit 1C may further include the input switch circuit 70 configured to switch the connection of the switched-capacitor circuit 20 between the pre-regulator circuits 11 and 12.

This allows the connection of the switched-capacitor circuit 20 to be switched between the pre-regulator circuits 11 and 12, thus making it possible to switch the combination of the power amplifiers 2C and 2D to be operated simultaneously with the power amplifiers 2A and 2B to which the power supply voltage is supplied from the tracker circuit 1C. That is, when the pre-regulator circuit 11 is connected to the switched-capacitor circuit 20, the power supply voltage can be simultaneously supplied to the power amplifier 2A or 2B and the power amplifier 2D. When the pre-regulator circuit 12 is connected to the switched-capacitor circuit 20, on the other hand, the power supply voltage can be simultaneously supplied to the power amplifier 2A or 2B and the power amplifier 2C.

### (Embodiment 3)

Next, Embodiment 3 will be described. A tracker circuit 1D according to this embodiment is mainly different from the tracker circuit 1A according to Embodiment 1 in that the tracker circuit 1D includes a plurality of supply modulators and can simultaneously supply a plurality of different discrete voltages to a plurality of power amplifiers. This embodiment will be described below with reference to Fig. 13, focusing on differences from Embodiment 1. Fig. 13 is a circuit configuration diagram of the tracker circuit 1D according to this embodiment.

Note that Fig. 13 illustrates an exemplary circuit configuration. The tracker circuit 1D can be implemented using any of a wide variety of circuit implementations and circuit technologies. Therefore, the description of the tracker circuit 1D provided below should not be interpreted as being limited thereto.

The communication device 7D according to this embodiment is the same as the communication device 7A according to Embodiment 1, except that the communication device 7D includes a tracker circuit 1D instead of the tracker circuit 1A, and therefore illustration and description thereof will be omitted here. In the communication device 7D according to this embodiment, a power amplifier 2B is an example of a fourth power amplifier, and an external connection terminal 103 is an example of a fourth external connection terminal.

### [3.1 Circuit Configuration of Tracker Circuit 1D]

The tracker circuit 1D includes a switched-capacitor circuit 20, supply modulators 31 and 32, filter circuits 41 and 42, a digital control circuit 60, external connection terminals 101 to 103, bypass paths BP1 and BP3, and switches S66 and S68.

The supply modulator 32 is an example of a second supply modulator, which is configured to selectively output at least one of a plurality of discrete voltages generated by the switched-capacitor circuit 20 to the power amplifier 2B. That is, the supply modulator 32 can select at least one voltage from among the plurality of discrete voltages and output the selected at least one voltage to the power amplifier 2B. In this event, the supply modulator 32 can discretely change over time the level of the voltage outputted to the power amplifier 2B by repeating the selection operation. Such a supply modulator 32 has the same circuit configuration as that of the supply modulator 31, and is controlled based on a digital control signal. In the supply modulator 32, input terminals 131 to 134 are an example of a plurality of third input terminals, and an output terminal 130 is an example of a third output terminal.

The filter circuit 42 is an example of a second filter circuit, which is connected between the supply modulator 32 and the power amplifier 2B (external connection terminal 103). The filter circuit 42 is configured to attenuate noise components from signals (a plurality of discrete voltages) from the supply modulator 32. Such a filter circuit 42 has the same circuit configuration as that of the filter circuit 41.

The bypass path BP1 is an example of a first bypass path, which is configured to bypass the switched-capacitor circuit 20 and the supply modulator 31 to output a regulating voltage from the pre-regulator circuit 11 to the power amplifier 2A. Specifically, the bypass path BP1 connects between the external connection terminals 101 and 102 without passing through the switched-capacitor circuit 20 and the supply modulator 31. In Fig. 13, the bypass path BP1 is connected to the input terminal of the filter circuit 41 and connected to the external connection terminal 102 through the filter circuit 41. However, the bypass path BP1 may be connected directly to the external connection terminal 102 without passing through the filter circuit 41.

The bypass path BP3 is an example of a third bypass path, which is configured to bypass the switched-capacitor circuit 20 and the supply modulator 32 to output the regulating voltage from the pre-regulator circuit 11 to the power amplifier 2B. Specifically, the bypass path BP3 connects between the external connection terminals 101 and 103 without passing through the switched-capacitor circuit 20 and the supply modulator 32. In Fig. 13, the bypass path BP3 is connected to the input terminal of the filter circuit 42 and connected to the external connection terminal 103 through the filter circuit 42. However, the bypass path BP3 may be connected directly to the external connection terminal 103 without passing through the filter circuit 42.

The switch S66 is an example of a first switch, which is configured to switch between connection and disconnection of the bypass path BP1. Specifically, the switch S66 is connected between the external connection terminals 101 and 102 on the bypass path BP1. That is, one end of the switch S66 is connected to the external connection terminal 101, and the other end of the switch S66 is connected to the external connection terminal 102 through the filter circuit 41.

The switch S68 is an example of a fifth switch, which is configured to switch between connection and disconnection of the bypass path BP3. Specifically, the switch S68 is connected between the external connection terminals 101 and 103 on the bypass path BP3. That is, one end of the switch S68 is connected to the external connection terminal 101, and the other end of the switch S68 is connected to the external connection terminal 103 through the filter circuit 42.

### [3.2 Effects and the like]

As described above, the tracker circuit 1D according to this embodiment may further include: the supply modulator 32 configured to selectively output at least one of the plurality of discrete voltages to the power amplifier 2B; the bypass path BP3 configured to bypass the switched-capacitor circuit 20 and the supply modulator 32 to output the first input voltage to the power amplifier 2B; and the switch S68 configured to switch between connection and non-connection of the bypass path BP3.

From another perspective, the tracker circuit 1D according to this embodiment may further include: the external connection terminal 103 connected to the power amplifier 2B; the supply modulator 32 including the input terminals 131 to 134 connected to the output terminals 121 to 124, respectively, and the output terminal 130 connected to the external connection terminal 103; the bypass path BP3 connecting between the external connection terminals 101 and 103 without passing through the switched-capacitor circuit 20 and the supply modulator 32; and the switch S68 connected between the external connection terminals 101 and 103 on the bypass path BP3.

With this configuration, since the tracker circuit 1D includes the supply modulators 31 and 32, different power supply voltages V_{T1} and V_{T2} can be simultaneously supplied from the tracker circuit 1D to the two power amplifiers 2A and 2B. In this case, the pre-regulator circuit 11 and the switched-capacitor circuit 20 can be shared by the two power amplifiers 2A and 2B, making it possible to contribute to reduction in the number of components and size reduction of the communication device 7D.

For example, the tracker circuit 1D according to this embodiment may further include the filter circuit 41 connected between the supply modulator 31 and the power amplifier 2A (external connection terminal 102) and the filter circuit 42 connected between the supply modulator 32 and the power amplifier 2B.

This allows the filter circuit 41 to reduce the noise components of the power supply voltage supplied to the power amplifier 2A and the filter circuit 42 to reduce the noise components of the power supply voltage supplied to the power amplifier 2B. This makes it possible to reduce distortion in the power amplifiers 2A and 2B.

### (Embodiment 4)

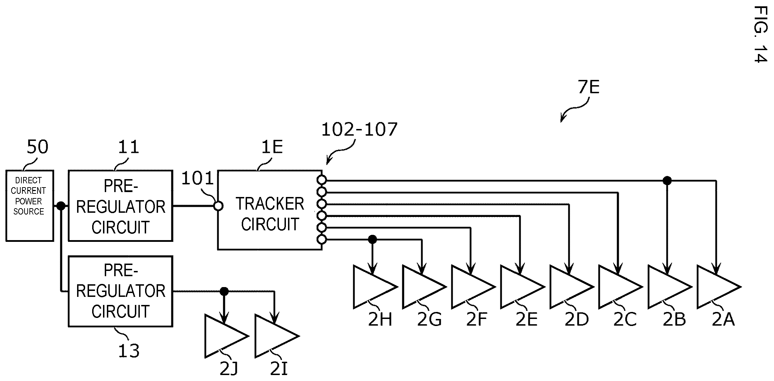

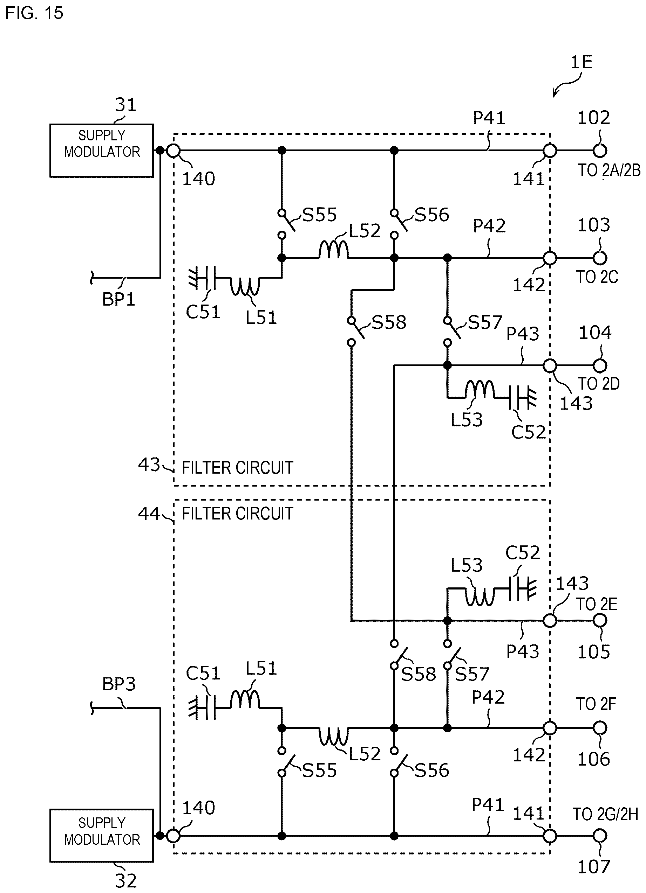

Next, Embodiment 4 will be described. A tracker circuit 1E according to this embodiment is mainly different from the tracker circuit 1D according to Embodiment 3 in that the tracker circuit 1E can supply power supply voltage to more power amplifiers. The tracker circuit 1E according to this embodiment will be described below with reference to Figs. 14 and 15, focusing on differences from the tracker circuit 1D according to Embodiment 3.

Fig. 14 is a partial circuit configuration diagram of a communication device 7E according to this embodiment. Fig. 15 is a partial circuit configuration diagram of the tracker circuit 1E according to this embodiment.

Note that Figs. 14 and 15 illustrate exemplary circuit configurations, and the communication device 7E and the tracker circuit 1E can be implemented using any of a wide variety of circuit implementations and circuit technologies. Therefore, the description of the communication device 7E and the tracker circuit 1E provided below should not be interpreted as being limited thereto.

### [4.1 Circuit Configuration of Communication Device 7E]

First, the communication device 7E according to this embodiment will be described with reference to Fig. 14. The communication device 7E includes the tracker circuit 1E, power amplifiers 2A to 2J, pre-regulator circuits 11 and 13, and a DC power source 50.

The tracker circuit 1E includes a switched-capacitor circuit 20, supply modulators 31 and 32, filter circuits 43 and 44, a digital control circuit 60, external connection terminals 101 to 107, bypass paths BP1 and BP3, and switches S66 and S68. The configuration of the tracker circuit 1E will be described later.

The power amplifiers 2A to 2H are each connected to the tracker circuit 1E and can receive a power supply voltage based on the digital ET mode or the APT mode. The power amplifiers 2A to 2H can use the power supply voltage received from the tracker circuit 1E to amplify RF signals of bands A to H received from an RFIC 5, respectively.

The power amplifiers 2I and 2J are each connected to the pre-regulator circuit 13 and can receive a power supply voltage based on the APT mode. The power amplifiers 2I and 2J can use the power supply voltage received from the pre-regulator circuit 13 to amplify RF signals of bands I and J received from the RFIC 5, respectively.

The bands A to J are frequency bands for a communication system built using a RAT, which are predefined by a standardizing body or the like.

For example, frequency bands included in the ultra-high band group are used as the bands A and B. Specifically, n77 and n79 for 5GNR, for example, are used as the bands A and B.

A frequency band included in the high band group (2300 to 2690 MHz), for example, is used as the band C. Specifically, Band 7, Band 30, Band 40 or Band 41 for LTE, or n7, n30, n40 or n41 for 5GNR, or any combination thereof, for example, is used as the band C.

A frequency band included in a mid-band group (1427 to 2200 MHz), for example, is used as the band D. Specifically, Band 1, Band 3, Band 25, Band 34, Band 39 or Band 66 for LTE, or n1, n3, n25, n34, n39 or n66 for 5GNR, or any combination thereof, for example, is used as the band D.

A frequency band included in the mid-band group, for example, is used as the band E. Specifically, Band 1, Band 3, Band 25, Band 34, Band 39 or Band 66 for LTE, or n1, n3, n25, n34, n39 or n66 for 5GNR, or any combination thereof, for example, is used as the band E.

A frequency band included in the high-band group, for example, is used as the band F. Specifically, Band 7, Band 30, Band 40 or Band 41 for LTE, or n7, n30, n40 or n41 for 5GNR, or any combination thereof, for example, is used as the band F.

As the bands G and H, frequency bands included in the ultra-high band group are used, for example. Specifically, n77 and n79 for 5GNR, for example, are used as the bands G and H.

A frequency band included in the low band group, for example, is used as the band I. Specifically, Band 5, Band 8, Band 26 or Band 28 for LTE, or n5, n8, n26 or n28 for 5GNR, or any combination thereof is used as the band I.

A frequency band for the 2G communication system, for example, is used as the band J.

The pre-regulator circuit 13 is configured to convert a voltage from the DC power source 50 into a regulating voltage. The pre-regulator circuit 13 can then output the regulating voltage to the power amplifiers 2J and 2I. The pre-regulator circuit 13 has the same circuit configuration as that of the pre-regulator circuit 11, and thus description thereof will be omitted.

### [4.2 Circuit Configuration of Tracker Circuit 1E]

Next, the circuit configuration of the tracker circuit 1E will be described with reference to Fig. 15.

The tracker circuit 1E includes a switched-capacitor circuit 20 (not illustrated), supply modulators 31 and 32, filter circuits 43 and 44, a digital control circuit 60 (not illustrated), external connection terminals 101 to 107, bypass paths BP1 and BP3, and switches S66 and S68 (not illustrated).

The external connection terminals 102 to 107 are connected to the power amplifiers 2A to 2H outside the tracker circuit 1E and are connected to the filter circuit 43 or 44 inside the tracker circuit 1E. The external connection terminals 102 to 107 are terminals for supplying power supply voltages to the power amplifiers 2A to 2H.

The filter circuit 43 is connected between the supply modulator 31 and the power amplifiers 2A to 2D (external connection terminals 102 to 104), and is configured to attenuate noise components from signals (a plurality of discrete voltages) from the supply modulator 31.

Specifically, the filter circuit 43 includes an input terminal 140, output terminals 141 to 143, inductors L51 to L53, capacitors C51 and C52, switches S55 to S58, and voltage supply paths P41 to P43.

The input terminal 140 is connected to an output terminal 130 of the supply modulator 31 outside the filter circuit 43, and is connected to the output terminal 141 inside the filter circuit 43.

The output terminal 141 is connected to the external connection terminal 102 of the tracker circuit 1E outside the filter circuit 43, and is connected to the input terminal 140 inside the filter circuit 43.

The output terminal 142 is connected to the external connection terminal 103 of the tracker circuit 1E outside the filter circuit 43, and is connected to the input terminal 140 inside the filter circuit 43.

The output terminal 143 is connected to the external connection terminal 104 of the tracker circuit 1E outside the filter circuit 43, and is connected to the input terminal 140 inside the filter circuit 43.

The voltage supply path P41 is a part of a path connecting between the supply modulator 31 and the power amplifiers 2A and 2B (external connection terminals 102). Here, the voltage supply path P41 is a path that directly connects between the input terminal 140 and the output terminal 141. That is, in this embodiment, no circuit elements (active elements and passive elements) are connected between the input terminal 140 and the output terminal 141 on the voltage supply path P41. Note that a circuit element may be connected between the input terminal 140 and the output terminal 141 on the voltage supply path P41.

The voltage supply path P42 is a part of a path connecting between the supply modulator 31 and the power amplifier 2C (external connection terminal 103). Here, the voltage supply path P42 is a path that connects between the input terminal 140 and the output terminal 142, and partially overlaps with the voltage supply path P41. Note that the voltage supply path P42 does not necessarily have to overlap with the voltage supply path P41.

The voltage supply path P43 is a part of a path connecting between the supply modulator 31 and the power amplifier 2D (external connection terminal 104). Here, the voltage supply path P42 is a path that connects between the input terminal 140 and the output terminal 143, and partially overlaps with the voltage supply paths P41 and P42. Note that the voltage supply path P43 does not necessarily have to overlap with the voltage supply paths P41 and P42.

The inductor L51 is connected in series to the capacitor C51. Specifically, one end of the inductor L51 is connected to a path between the switch S55 and the inductor L52 in the voltage supply path P42. The other end of the inductor L51 is connected to the capacitor C51.

The capacitor C51 is connected between the inductor L51 and the ground. Specifically, one end of the capacitor C51 is connected to the inductor L51, and the other end of the capacitor C51 is connected to the ground.

The inductor L52 is connected between the input terminal 140 and the output terminal 142 on the voltage supply path P42. Specifically, one end of the inductor L52 is connected to the switch S55 and the inductor L51, and the other end of the inductor L52 is connected to the switch S56 and the output terminal 142.

The inductor L53 is connected in series to the capacitor C52. Specifically, one end of the inductor L53 is connected to a path between the switch S57 and the output terminal 143 in the voltage supply path P43. The other end of the inductor L53 is connected to the capacitor C52.

The capacitor C52 is connected between the inductor L53 and the ground. Specifically, one end of the capacitor C52 is connected to the inductor L53, and the other end of the capacitor C52 is connected to the ground.

The switch S55 is connected between the voltage supply path P41 and the inductors L51 and L52. Specifically, one end of the switch S55 is connected to the voltage supply path P41, and the other end of the switch S55 is connected to the inductors L51 and L52.

The switch S56 is connected between the voltage supply paths P41 and P42. Specifically, one end of the switch S56 is connected to the voltage supply path P41, and the other end of the switch S56 is connected to a path between the inductor L52 and the output terminal 142 in the voltage supply path P42.

The switch S57 is connected between the voltage supply path P42, the inductor L53, and the output terminal 143. Specifically, one end of the switch S57 is connected to a path between the inductor L52 and the output terminal 142 in the voltage supply path P42. The other end of the switch S57 is connected to the inductor L53 and the output terminal 143.

The switch S58 is connected between the voltage supply path P42 and the voltage supply path P43 of the filter circuit 44. Specifically, one end of the switch S58 is connected to a path between the inductor L52 and the output terminal 142 in the voltage supply path P42. The other end of the switch S58 is connected to a path between the switch S57 and the output terminal 143 in the voltage supply path P43 of the filter circuit 44.

The switches S55 to S57 thus connected can be switched on and off based on the control signal S4 to function as changeover switches for the output terminals 141 to 143 and as variable band elimination filters. For example, by closing the switch S55 and opening the switch S56, the inductor L51 and the capacitor C51 are connected between the voltage supply path P41 and the ground. This allows the filter circuit 43 to function as a band elimination filter having a first stopband on the voltage supply path P41. By opening the switch S55 and closing the switch S56, for example, on the other hand, the inductors L51 and L52 and the capacitor C51 are connected between the voltage supply path P41 and the ground. This allows the filter circuit 43 to function as a band elimination filter having a second stopband different from the first stopband on the voltage supply path P41. Such on and off of the switches S55 to S57 can be controlled based on a channel band width (that is, modulation band width) of an RF signal, for example.

The switch S58 can also be switched on and off based on the control signal S4 to switch between connection and disconnection of the supply modulator 31 to the filter circuit 44.

The filter circuit 44 is connected between the supply modulator 32 and the power amplifiers 2E to 2H (external connection terminals 105 to 107), and is configured to attenuate noise components from signals (a plurality of discrete voltages) from the supply modulator 32. The internal configuration of the filter circuit 44 is the same as that of the filter circuit 43, and thus description thereof will be omitted.

### [4.3 Effects and the like]

As described above, the tracker circuit 1E according to this embodiment makes it possible to supply the power supply voltage based on the digital ET mode simultaneously to any of the power amplifiers 2A and/or 2B, the power amplifier 2C, and the power amplifier 2D, and to any of the power amplifiers 2E, 2F, 2G and/or 2H. The tracker circuit 1E also makes it possible, by closing the switch S58 of the filter circuit 43, to supply the power supply voltage based on the digital ET mode simultaneously to any of the power amplifiers 2A and/or 2B and the power amplifier 2C and to the power amplifier 2D. The tracker circuit 1E also makes it possible, by closing the switch S58 of the filter circuit 44, to supply the power supply voltage based on the digital ET mode simultaneously to the power amplifier 2E and to any of the power amplifier 2F and the power amplifiers 2G and/or 2H. That is, the tracker circuit 1E can supply the power supply voltage simultaneously to the combinations 1 to 8 of the power amplifiers 2A to 2H in Table 1 below.

**[Table 1]**

| | 2A | 2B | 2C | 2D | 2E | 2F | 2G | 2H |
|---|---|---|---|---|---|---|---|---|
| 1 | ✔ | | | | | | ✔ | |
| 2 | | ✔ | | | | | | ✔ |
| 3 | | | | ✔ | ✔ | | | |
| 4 | | | ✔ | | | ✔ | | |
| 5 | ✔ | | | | | | | ✔ |
| 6 | ✔ | | | | ✔ | | | |
| 7 | ✔ | | | | | ✔ | | |
| 8 | | | | ✔ | | ✔ | | |

### (Other Embodiments)

The tracker circuit and the tracking method according to the present invention have been described above based on the embodiments, but the tracker circuit and the tracking method according to the present invention are not limited to the above embodiments. The present invention also includes other embodiments realized by combining any of the components in the above embodiments, modifications obtained by applying various modifications to the above embodiments that can be conceived by those skilled in the art without departing from the spirit of the present invention, and various devices including the above tracker circuit.

For example, in the circuit configuration of the various circuits according to the above embodiments, other circuit elements, wiring, and the like may be inserted between the paths connecting the circuit elements and signal paths disclosed in the drawings. For example, an impedance matching circuit may be inserted between the power amplifier 2A and the filter 3A.

In the above embodiments, a plurality of discrete voltages are supplied to the supply modulator from the switched-capacitor circuit, but the present invention is not limited thereto. For example, a plurality of voltages may be supplied to the supply modulator from a plurality of DC-to-DC converters. When the voltage levels of the plurality of discrete voltages are equally spaced, it is preferable to use a switched-capacitor circuit, which is effective in reducing the size of the tracker module.

In the above embodiments, four discrete voltages are supplied to the power amplifier, but the number of the discrete voltages is not limited to four. For example, when the plurality of discrete voltages include at least a voltage corresponding to the maximum output power and a voltage corresponding to the most frequently occurring output power, the power-added efficiency can be improved.

The plurality of circuit components of the tracker circuit 1A are arranged on the main surface 90a of the module laminate 90 in Embodiment 1 described above, but may be arranged separately on both the main surfaces 90a and 90b. In this case, the integrated circuit 80, for example, may be arranged on the main surface 90b.

The features of the tracker circuit and the tracking method described based on the above embodiments will be described below.

<1> A tracker circuit including:
   a converter circuit configured to generate a plurality of discrete voltages based on a first input voltage;
   a first supply modulator configured to selectively output at least one of the plurality of discrete voltages to a first power amplifier;
   a first bypass path configured to bypass the converter circuit and the first supply modulator to output the first input voltage to the first power amplifier; and
   a first switch configured to switch between connection and disconnection of the first bypass path.
<2> The tracker circuit according to <1>, in which
   when a first power class is applied to a radio frequency signal amplified by the first power amplifier, the first switch disconnects the first bypass path,
   when a second power class is applied to a radio frequency signal amplified by the first power amplifier, the first switch connects the first bypass path, and
   the first power class allows maximum output power higher than the second power class.
<3> The tracker circuit according to <1> or <2>, further including:
   a first filter circuit connected between the first supply modulator and the first power amplifier.
<4> The tracker circuit according to <3>, in which
   the first supply modulator is also configured to selectively output at least one of the plurality of discrete voltages to the second power amplifier, and
   the first filter circuit is also connected between the first supply modulator and the second power amplifier.
<5> The tracker circuit according to <4>, in which
   the first bypass path is also configured to output the first input voltage to the second power amplifier.
<6> The tracker circuit according to <4>, further including:
   a second bypass path configured to bypass the converter circuit and the first supply modulator to output the first input voltage to the second power amplifier; and
   a second switch configured to switch between connection and non-connection of the second bypass path.
<7> The tracker circuit according to any one of <4> to <6>, in which
   the first filter circuit includes a first inductor, a second inductor, a first capacitor, a third switch, and a fourth switch,
   one end of the third switch is connected to a first voltage supply path connecting between the first supply modulator and the first power amplifier, and the other end of the third switch is connected to the first inductor and the second inductor,
   one end of the fourth switch is connected to the first voltage supply path, and the other end of the fourth switch is connected to a path between the second inductor and the second power amplifier in a second voltage supply path connecting between the first supply modulator and the second power amplifier,
   one end of the first inductor is connected to a path between the third switch and the second inductor in the second voltage supply path, and the other end of the first inductor is connected to the first capacitor,
   one end of the first capacitor is connected to the first inductor, and the other end of the first capacitor is connected to ground, and
   one end of the second inductor is connected to the third switch and the first inductor, and the other end of the second inductor is connected to the fourth switch and the second power amplifier.
<8> The tracker circuit according to any one of <1> to <7>, in which
   the converter circuit is a second converter circuit connected to a first converter circuit configured to convert a voltage from a direct current power source into the first input voltage, and
   the first converter circuit is configured to output the first input voltage to the second converter circuit and to output the first input voltage to a third power amplifier without passing through the second converter circuit.
<9> The tracker circuit according to <8>, in which
   the second converter circuit is further connected to a third converter circuit configured to convert a voltage from the direct current power source into a second input voltage, and is configured to generate the plurality of discrete voltages based on the second input voltage, and
   the tracker circuit further includes an input switch circuit configured to switch connection of the second converter circuit between the first converter circuit and the third converter circuit.
<10> The tracker circuit according to any one of <1> to <9>, further including:
   a second supply modulator configured to selectively output at least one of the plurality of discrete voltages to a fourth power amplifier;
   a third bypass path configured to bypass the converter circuit and the second supply modulator to output the first input voltage to the fourth power amplifier; and
   a fifth switch configured to switch between connection and non-connection of the third bypass path.
<11> The tracker circuit according to <10>, further including:
   a first filter circuit connected between the first supply modulator and the first power amplifier; and
   a second filter circuit connected between the second supply modulator and the fourth power amplifier.
<12> A tracker circuit including:
   a first external connection terminal for receiving a first input voltage;
   a second external connection terminal connected to a first power amplifier;
   a switched-capacitor circuit including a first input terminal and a plurality of first output terminals, the first input terminal being connected to the first external connection terminal;
   a first supply modulator including a plurality of second input terminals and a second output terminal, the plurality of second input terminals being connected to the plurality of first output terminals, the second output terminal being connected to the second external connection terminal;
   a first bypass path connecting between the first external connection terminal and the second external connection terminal without passing through the switched-capacitor circuit and the first supply modulator; and
   a first switch connected between the first external connection terminal and the second external connection terminal on the first bypass path.
<13> The tracker circuit according to <12>, further including:
   a first filter circuit connected between the first supply modulator and the second external connection terminal.
<14> The tracker circuit according to <13>, in which
   the first supply modulator further includes a third external connection terminal connected to a second power amplifier, and
   the first filter circuit is further connected between the first supply modulator and the third external connection terminal.
<15> The tracker circuit according to <14>, in which
   the first bypass path further connects between the first external connection terminal and the third external connection terminal without passing through the switched-capacitor circuit and the first supply modulator.
<16> The tracker circuit according to <14>, further including:
   a second bypass path connecting between the first external connection terminal and the third external connection terminal without passing through the switched-capacitor circuit and the first supply modulator; and
   a second switch connected between the first external connection terminal and the third external connection terminal on the second bypass path.
<17> The tracker circuit according to any one of <14> to <16>, in which
   the first filter circuit includes a first inductor, a second inductor, a first capacitor, a third switch, and a fourth switch,
   one end of the third switch is connected to a first voltage supply path connecting between the first supply modulator and the second external connection terminal, and the other end of the third switch is connected to the first inductor and the second inductor,
   one end of the fourth switch is connected to the first voltage supply path, and the other end of the fourth switch is connected to a path between the second inductor and the third external connection terminal in a second voltage supply path connecting between the first supply modulator and the third external connection terminal,
   one end of the first inductor is connected to a path between the third switch and the second inductor in the second voltage supply path, and the other end of the first inductor is connected to the first capacitor,
   one end of the first capacitor is connected to the first inductor, and the other end of the first capacitor is connected to ground, and
   one end of the second inductor is connected to the third switch and the first inductor, and the other end of the second inductor is connected to the fourth switch and the third external connection terminal.
<18> The tracker circuit according to any one of <12> to <17>, further including:
   a fourth external connection terminal connected to a fourth power amplifier;
   a second supply modulator including a plurality of third input terminals and a third output terminal, the plurality of third input terminals being connected to the plurality of first output terminals, the third output terminal being connected to the fourth external connection terminal;
   a third bypass path connecting between the first external connection terminal and the fourth external connection terminal without passing through the switched-capacitor circuit and the second supply modulator; and
   a fifth switch connected between the first external connection terminal and the fourth external connection terminal on the third bypass path.
<19> The tracker circuit according to <18>, further including:
   a first filter circuit connected between the first supply modulator and the first external connection terminal; and
   a second filter circuit connected between the second supply modulator and the fourth external connection terminal.
<20> A tracking method including:
   in a case of operating a power amplifier in a digital envelope tracking mode,
      (i) disconnecting a bypass path connecting between a first external connection terminal and a second external connection terminal;
      (ii) generating a plurality of discrete voltages based on an input voltage received through the first external connection terminal; and
      (iii) selectively supplying at least one of the plurality of discrete voltages to the power amplifier through the second external connection terminal, based on an envelope of a radio frequency signal amplified by the power amplifier, and
   in a case of operating the power amplifier in an average power tracking mode,
      (i) connecting the bypass path; and
      (ii) supplying an input voltage received through the first external connection terminal to the power amplifier through the bypass path and the second external connection terminal.

### Industrial Applicability

The present invention can be widely used as a tracker circuit that supplies a voltage to a power amplifier in a communication device such as a mobile phone.

### Reference Signs List

1A, 1B, 1C, 1D, 1E TRACKER CIRCUIT
2A, 2B, 2C, 2D, 2E, 2F, 2G, 2H, 2I, 2J POWER AMPLIFIER
3A, 3B, 3C, 3D FILTER
5 RFIC
6A, 6B, 6C, 6D ANTENNA
7A, 7C, 7D, 7E COMMUNICATION DEVICE
11, 12, 13 PRE-REGULATOR CIRCUIT
20 SWITCHED-CAPACITOR CIRCUIT
31, 32 SUPPLY MODULATOR
41, 42, 43, 44 FILTER CIRCUIT
50 DIRECT CURRENT (DC) POWER SOURCE
60 DIGITAL CONTROL CIRCUIT
61 FIRST CONTROLLER
62 SECOND CONTROLLER
70 INPUT SWITCH CIRCUIT
80 INTEGRATED CIRCUIT
80b SC SWITCH PORTION
80c OS SWITCH PORTION
80d FILTER SWITCH PORTION
90 MODULE LAMINATE
90a, 90b MAIN SURFACE
90e GROUND PLANE
91 RESIN MEMBER
92 SHIELD ELECTRODE LAYER
100 TRACKER MODULE
101, 101a, 101b, 101c, 101d, 102, 103, 104, 105, 106, 107 EXTERNAL CONNECTION TERMINAL
110, 120, 120a, 120b, 120c, 120d, 131, 132, 133, 134, 140 INPUT TERMINAL
111, 112, 113, 114, 121, 122, 123, 124, 130, 141, 142, 143 OUTPUT TERMINAL
150 ELECTRODE
601, 602, 603, 604 CONTROL TERMINAL
BP1, BP2, BP3 BYPASS PATH

## Claims

1. A tracker circuit comprising:
a converter circuit configured to generate a plurality of discrete voltages based on a first input voltage;
a first supply modulator configured to selectively output at least one of the plurality of discrete voltages to a first power amplifier;
a first bypass path configured to bypass the converter circuit and the first supply modulator to output the first input voltage to the first power amplifier; and
a first switch configured to switch between connection and disconnection of the first bypass path.

2. The tracker circuit according to claim 1, wherein
when a first power class is applied to a radio frequency signal amplified by the first power amplifier, the first switch disconnects the first bypass path,
when a second power class is applied to a radio frequency signal amplified by the first power amplifier, the first switch connects the first bypass path, and
the first power class allows maximum output power higher than the second power class.

3. The tracker circuit according to claim 1 or 2, further comprising:
a first filter circuit connected between the first supply modulator and the first power amplifier.

4. The tracker circuit according to claim 3, wherein
the first supply modulator is also configured to selectively output at least one of the plurality of discrete voltages to the second power amplifier, and
the first filter circuit is also connected between the first supply modulator and the second power amplifier.

5. The tracker circuit according to claim 4, wherein
the first bypass path is also configured to output the first input voltage to the second power amplifier.

6. The tracker circuit according to claim 4, further comprising:
a second bypass path configured to bypass the converter circuit and the first supply modulator to output the first input voltage to the second power amplifier; and
a second switch configured to switch between connection and non-connection of the second bypass path.

7. The tracker circuit according to any one of claims 4 to 6, wherein
the first filter circuit includes a first inductor, a second inductor, a first capacitor, a third switch, and a fourth switch,
one end of the third switch is connected to a first voltage supply path connecting between the first supply modulator and the first power amplifier, and the other end of the third switch is connected to the first inductor and the second inductor,
one end of the fourth switch is connected to the first voltage supply path, and the other end of the fourth switch is connected to a path between the second inductor and the second power amplifier in a second voltage supply path connecting between the first supply modulator and the second power amplifier,
one end of the first inductor is connected to a path between the third switch and the second inductor in the second voltage supply path, and the other end of the first inductor is connected to the first capacitor,
one end of the first capacitor is connected to the first inductor, and the other end of the first capacitor is connected to ground, and
one end of the second inductor is connected to the third switch and the first inductor, and the other end of the second inductor is connected to the fourth switch and the second power amplifier.

8. The tracker circuit according to any one of claims 1 to 7, wherein
the converter circuit is a second converter circuit connected to a first converter circuit configured to convert a voltage from a direct current power source into the first input voltage, and
the first converter circuit is configured to output the first input voltage to the second converter circuit and to output the first input voltage to a third power amplifier without passing through the second converter circuit.

9. The tracker circuit according to claim 8, wherein
the second converter circuit is further connected to a third converter circuit configured to convert a voltage from the direct current power source into a second input voltage, and is configured to generate the plurality of discrete voltages based on the second input voltage, and
the tracker circuit further includes an input switch circuit configured to switch connection of the second converter circuit between the first converter circuit and the third converter circuit.

10. The tracker circuit according to any one of claims 1 to 9, further comprising:
a second supply modulator configured to selectively output at least one of the plurality of discrete voltages to a fourth power amplifier;
a third bypass path configured to bypass the converter circuit and the second supply modulator to output the first input voltage to the fourth power amplifier; and
a fifth switch configured to switch between connection and non-connection of the third bypass path.

11. The tracker circuit according to claim 10, further comprising:
a first filter circuit connected between the first supply modulator and the first power amplifier; and
a second filter circuit connected between the second supply modulator and the fourth power amplifier.

12. A tracker circuit comprising:
a first external connection terminal for receiving a first input voltage;
a second external connection terminal connected to a first power amplifier;
a switched-capacitor circuit including a first input terminal and a plurality of first output terminals, the first input terminal being connected to the first external connection terminal;
a first supply modulator including a plurality of second input terminals and a second output terminal, the plurality of second input terminals being connected to the plurality of first output terminals, the second output terminal being connected to the second external connection terminal;
a first bypass path connecting between the first external connection terminal and the second external connection terminal without passing through the switched-capacitor circuit and the first supply modulator; and
a first switch connected between the first external connection terminal and the second external connection terminal on the first bypass path.

13. The tracker circuit according to claim 12, further comprising:
a first filter circuit connected between the first supply modulator and the second external connection terminal.

14. The tracker circuit according to claim 13, wherein
the first supply modulator further includes a third external connection terminal connected to a second power amplifier, and
the first filter circuit is further connected between the first supply modulator and the third external connection terminal.

15. The tracker circuit according to claim 14, wherein
the first bypass path further connects between the first external connection terminal and the third external connection terminal without passing through the switched-capacitor circuit and the first supply modulator.

16. The tracker circuit according to claim 14, further comprising:
a second bypass path connecting between the first external connection terminal and the third external connection terminal without passing through the switched-capacitor circuit and the first supply modulator; and
a second switch connected between the first external connection terminal and the third external connection terminal on the second bypass path.

17. The tracker circuit according to any one of claims 14 to 16, wherein
the first filter circuit includes a first inductor, a second inductor, a first capacitor, a third switch, and a fourth switch,
one end of the third switch is connected to a first voltage supply path connecting between the first supply modulator and the second external connection terminal, and the other end of the third switch is connected to the first inductor and the second inductor,
one end of the fourth switch is connected to the first voltage supply path, and the other end of the fourth switch is connected to a path between the second inductor and the third external connection terminal in a second voltage supply path connecting between the first supply modulator and the third external connection terminal,
one end of the first inductor is connected to a path between the third switch and the second inductor in the second voltage supply path, and the other end of the first inductor is connected to the first capacitor,
one end of the first capacitor is connected to the first inductor, and the other end of the first capacitor is connected to ground, and
one end of the second inductor is connected to the third switch and the first inductor, and the other end of the second inductor is connected to the fourth switch and the third external connection terminal.

18. The tracker circuit according to any one of claims 12 to 17, further comprising:
a fourth external connection terminal connected to a fourth power amplifier;
a second supply modulator including a plurality of third input terminals and a third output terminal, the plurality of third input terminals being connected to the plurality of first output terminals, the third output terminal being connected to the fourth external connection terminal;
a third bypass path connecting between the first external connection terminal and the fourth external connection terminal without passing through the switched-capacitor circuit and the second supply modulator; and
a fifth switch connected between the first external connection terminal and the fourth external connection terminal on the third bypass path.

19. The tracker circuit according to claim 18, further comprising:
a first filter circuit connected between the first supply modulator and the first external connection terminal; and
a second filter circuit connected between the second supply modulator and the fourth external connection terminal.

20. A tracking method comprising:
in a case of operating a power amplifier in a digital envelope tracking mode,
(i) disconnecting a bypass path connecting between a first external connection terminal and a second external connection terminal;
(ii) generating a plurality of discrete voltages based on an input voltage received through the first external connection terminal; and
(iii) selectively supplying at least one of the plurality of discrete voltages to the power amplifier through the second external connection terminal, based on an envelope of a radio frequency signal amplified by the power amplifier, and
in a case of operating the power amplifier in an average power tracking mode,
(i) connecting the bypass path; and
(ii) supplying an input voltage received through the first external connection terminal to the power amplifier through the bypass path and the second external connection terminal.
